# EUROPEAN PATENT APPLICATION

(11) **EP 4 276 884 A1**
(43) Date of publication of application: **15.11.2023**
(21) Application number: 22904341.9
(22) Date of filing: 09.12.2022
(51) Int. Cl.: H01L 21/304, H01L 21/66

(54) **WORK-AFFECTED LAYER EVALUATION METHOD AND EVALUATION SYSTEM**

(30) Priority: 10.12.2021 JP 2021200698
(71) Applicant: Kwansei Gakuin Educational Foundation, Nishinomiya-shi, Hyogo 662-8501 (JP); YGK Corporation, Alps-shi, Yamanashi 400-0311 (JP); Toyota Tsusho Corporation, Nagoya-shi Aichi 450-8575 (JP)
(72) Inventor: KANEKO, Tadaaki, Sanda-shi, Hyogo 669-1330 (JP); DOJIMA, Daichi, Sanda-shi, Hyogo 669-1330 (JP); ASAKAWA, Kazunobu, Alps-shi, Yamanashi 400-0311 (JP)
(74) Representative: dompatent von Kreisler Selting Werner - Partnerschaft von Patent- und Rechtsanwälten mbB
(86) International application number: PCT/JP2022/045532
(87) International publication number: WO 2023/106414

(57) **Abstract**

An object of the present invention is to provide a novel technology capable of evaluating a subsurface damaged layer without destroying a semiconductor substrate. As means for solving this object, the present invention includes a measurement step of causing laser light having penetration characteristics to be incident from a surface of a semiconductor substrate having a subsurface damaged layer under the surface and measuring an intensity of scattered light scattered under the surface, and an evaluation step of evaluating the subsurface damaged layer on the basis of the intensity of the scattered light obtained in the measurement step.

## Description

### Technical Field

The present invention relates to a method and a system for evaluating a subsurface damaged layer.

### Background Art

Typically, a semiconductor substrate (a so-called wafer) is formed by slicing an ingot of a semiconductor material and grinding/polishing a surface. On the surface of the semiconductor substrate, there is a surface layer (hereinafter, referred to as a subsurface damaged layer) having crystal strain, scratches, or the like introduced during slicing or grinding/polishing. This subsurface damaged layer is a factor that lowers the yield of a device in a manufacturing process of the device, and thus is preferably removed.

Conventionally, as a method for evaluating the presence or absence and degree of the subsurface damaged layer, a destructive inspection has been common. For example, in silicon carbide (SiC) that is a compound semiconductor material classified as a material that is extremely difficult to process, a subsurface damaged layer is evaluated by observing a cross section obtained by cleaving a semiconductor substrate by using an electron back scattered diffraction pattern (EBSD) method of a transmission electron microscope (TEM) or a scanning electron microscope (SEM) (refer to Patent Literature 1).

### Citation List

### Patent Literature

Patent Literature 1: JP 2020-017627 A

### Summary of Invention

### Technical Problem

As described above, the conventional evaluation of a subsurface damaged layer has been mainly performed according to a destructive inspection of cleaving a semiconductor substrate. Thus, a semiconductor substrate for which a subsurface damaged layer has been evaluated has a problem that the semiconductor substrate cannot be returned to a device manufacturing process. The destructive inspection is an inspection for locally evaluating a subsurface damaged layer, and has a problem that it is difficult to evaluate a distribution of the subsurface damaged layer in a surface of a semiconductor substrate over a wide range.

Various studies have been made to employ Raman spectroscopy for evaluating a subsurface damaged layer of a semiconductor substrate. On the other hand, in Raman spectroscopy, it is necessary to measure weak Raman scattering compared with elastic scattering such as Rayleigh scattering, and thus it takes time to evaluate the entire surface of one semiconductor substrate. Thus, in a case where Raman spectroscopy is introduced into a manufacturing process as a method for evaluating a subsurface damaged layer, there is a problem in that throughput is reduced.

In view of the above-described problems, an object of the present invention is to provide a novel technology capable of evaluating a subsurface damaged layer without destroying a semiconductor substrate.

Another object of the present invention is to provide a novel technology capable of evaluating a distribution of a subsurface damaged layer, more specifically, an amount of strain contained in the subsurface damaged layer and a distribution thereof at a high speed without destroying a semiconductor substrate.

### Solution to Problem

The present invention to solve the above-described problems is a method for evaluating a subsurface damaged layer of a semiconductor substrate, the method comprising:
a measurement step of causing laser light having penetration characteristics to be incident from a surface of a semiconductor substrate having a subsurface damaged layer under the surface and measuring an intensity of scattered light scattered under the surface; and an evaluation step of evaluating the subsurface damaged layer on the basis of the intensity of the scattered light obtained in the measurement step.

In a preferred mode of the present invention, the semiconductor substrate is a silicon carbide substrate.

In a preferred mode of the present invention, the subsurface damaged layer includes strain, and the evaluation step includes calculating an amount of the strain on the basis of the intensity of the scattered light.

The measurement step includes acquiring the intensity of the scattered light having a predetermined depth in association with position information in planar directions of the semiconductor substrate, and the evaluation step includes calculating the amount of strain in association with the position information.

In a preferred mode of the present invention, the laser light has a photon energy larger than a bandgap of the semiconductor substrate.

In a preferred mode of the present invention, the laser light has a photon energy of about 101 to 1220 of the bandgap of the semiconductor substrate.

In a preferred mode of the present invention, the method further includes a measurement step using S-polarized light in which S-polarized laser light is caused to be incident from the surface of the semiconductor substrate and an intensity of scattered light scattered under the surface is measured.

In a preferred mode of the present invention, the method further includes a measurement step using P-polarized light in which P-polarized laser light is caused to be incident from the surface of the semiconductor substrate and an intensity of scattered light scattered under the surface is measured.

In a preferred mode of the present invention, the method further includes a measurement step using S-polarized light in which S-polarized laser light is caused to be incident from the surface of the semiconductor substrate and an intensity of scattered light scattered under the surface is measured; and a measurement step using P-polarized light in which P-polarized laser light is caused to be incident from the surface and an intensity of scattered light scattered under the surface is measured.

In a preferred mode of the present invention, the semiconductor substrate has a planarized surface.

In a preferred mode of the present invention, the laser light is incident to the semiconductor substrate at an incident angle θ of 40° ≤ θ ≤ 80° with respect to a normal line of the surface of the semiconductor substrate.

In a preferred mode of the present invention, the method further includes an inspection region information acquisition step of acquiring information regarding an inspection region in a depth direction from the surface of the semiconductor substrate, in which the measurement step includes a light projection condition acquisition step of acquiring light projection conditions including penetration characteristics of the laser light such that the laser light penetrates into the inspection region; and a light selection step of selectively measuring scattered light generated in the inspection region.

In the present invention, the term "selectively measuring" is not limited to measuring only scattered light generated in the inspection region. The term includes not detecting a part of scattered light generated in a non-inspection region to an extent that an intensity of scattered light generated in an inspection region can be identified.

In a preferred mode of the present invention, the light selection step includes shielding scattered light generated in a non-inspection region outside the inspection region.

In a preferred mode of the present invention, the light selection step includes shielding reflected light and/or scattered light generated on a back surface of the semiconductor substrate.

In a preferred mode of the present invention, the measurement step includes a scanning step of scanning the semiconductor substrate with the laser light while rotating the semiconductor substrate.

In a preferred mode of the present invention, the measurement step is a step of measuring the scattered light including elastic scattering.

The present invention to solve the above-described problems is an evaluation system for a subsurface damaged layer, including a stage capable of holding a semiconductor substrate that is a measurement target; a light projection system capable of irradiating the semiconductor substrate with laser light having penetration characteristics; a light receiving system capable of receiving scattered light that is scattered under a surface of the semiconductor substrate; and a data processing unit configured to evaluate a subsurface damaged layer on the basis of an intensity of the scattered light measured by using the laser light.

In a preferred mode of the present invention, the subsurface damaged layer includes strain, and the data processing unit calculates an amount of the strain on the basis of the intensity of the scattered light.

In a preferred mode of the present invention, the light projection system irradiates the entire surface of the semiconductor substrate with the laser light, the light receiving system acquires the intensity of the scattered light scattered at a predetermined depth over planar directions of the semiconductor substrate in association with position information in the planar directions, and the data processing unit records the calculated amount of strain in association with the position information.

In a preferred mode of the present invention, the light projection system emits the laser light having a photon energy larger than a bandgap of the semiconductor substrate.

In a preferred mode of the present invention, the light projection system emits the laser light having a photon energy of about 101 to 1220 of the bandgap of the semiconductor substrate.

In a preferred mode of the present invention, the evaluation system further includes the stage capable of holding a semiconductor substrate that is a measurement target; the light projection system capable of emitting S-polarized and/or P-polarized laser light; the light receiving system capable of receiving scattered light that is scattered under a surface of the semiconductor substrate; and the data processing unit configured to evaluate a subsurface damaged layer on the basis of an intensity of the scattered light measured by using the S-polarized and/or P-polarized laser light.

In a preferred mode of the present invention, the light projection system irradiates the semiconductor substrate with the laser light at an incident angle θ of 40° ≤ θ ≤ 80° with respect to a normal line of the surface of the semiconductor substrate.

In a preferred mode of the present invention, the evaluation system further includes an inspection region setting unit that sets an inspection region in a depth direction from the surface of the semiconductor substrate, in which the light projection system determines light projection conditions including at least penetration characteristics such that the laser light penetrates into the inspection region, and the light receiving system determines light receiving conditions such that scattered light generated in the inspection region is selectively measured.

In the present invention, the term "selectively measuring" is not limited to measuring only scattered light generated in the inspection region. The term includes not detecting a part of scattered light generated in a non-inspection region to an extent that an intensity of scattered light generated in an inspection region can be identified.

In a preferred mode of the present invention, the light projection system includes an optical adjuster that adjusts the penetration characteristics of the laser light, and the light receiving system includes a light selector that selectively measures scattered light generated in the inspection region.

In a preferred mode of the present invention, the light selector includes a slit that shields scattered light generated in a non-inspection region outside the inspection region.

In a preferred mode of the present invention, the light selector includes a slit that shields reflected light and/or scattered light generated on a back surface of the semiconductor substrate.

In a preferred mode of the present invention, the semiconductor substrate is a silicon carbide substrate.

In a preferred mode of the present invention, the data processing unit extracts a location parameter and/or a scale parameter of the statistic calculated on the basis of the intensity of the scattered light.

The present invention to solve the above-described problem is a method for evaluating a semiconductor substrate, the method including: a data acquisition step of acquiring, as scattered light intensity data, an intensity measurement value of scattered light that is scattered under a surface of a semiconductor substrate, the intensity measurement value being measured by causing laser light to be incident from the surface of the semiconductor substrate, in association with measurement position information; a statistic calculation step of calculating a statistic of a plurality of intensity measurement values included in the scattered light intensity data; and an evaluation step of evaluating a subsurface damaged layer of the semiconductor substrate on the basis of the statistic.

In a preferred mode of the present invention, the semiconductor substrate is a silicon carbide substrate.

In a preferred mode of the present invention, the data acquisition step includes acquiring a plurality of types of the scattered light intensity data in which each of a plurality of types of the intensity measurement values measured by causing a plurality of pieces of laser light having different penetration characteristics to be incident is associated with measurement position information including planar directions and a depth direction of the semiconductor substrate, and the statistic calculation step includes calculating a statistic of the intensity measurement values in association with the measurement position information including the planar directions and the depth direction.

In a preferred mode of the present invention, the laser light has polarization characteristics.

In a preferred mode of the present invention, the laser light is S-polarized light and/or P-polarized light.

In a preferred mode of the present invention, the evaluation step includes a strain amount calculation step of calculating an amount of strain under the surface of the semiconductor substrate from the statistic.

In a preferred mode of the present invention, the evaluation step further includes a peak specifying step of specifying and labeling the intensity measurement value greater than a predetermined upper limit value.

In a preferred mode of the present invention, the semiconductor substrate has a planarized surface, and the evaluation step further includes a peak specifying step of specifying and labeling the intensity measurement value having a discontinuous numerical value in light of the measurement position information on the basis of the measurement position information and the intensity measurement value.

In a preferred mode of the present invention, the method further includes a mapping step of creating a distribution diagram of the intensity measurement values on the basis of threshold values for dividing the intensity measurement values from a lower limit to an upper limit into a plurality of values.

In a preferred mode of the present invention, the mapping step includes creating a distribution diagram of the intensity measurement values on the basis of a plurality of threshold values such that an amount of strain is identifiable in a stepwise manner.

In a preferred mode of the present invention, the evaluation step includes a population parameter extraction step of extracting a population parameter of the plurality of intensity measurement values, and an analysis step of analyzing the semiconductor substrate on the basis of the extracted population parameter.

In a preferred mode of the present invention, the population parameter extraction step includes a location parameter extraction step of extracting a location parameter of the plurality of intensity measurement values.

In a preferred mode of the present invention, the location parameter extraction step is a step of extracting a most frequent value of the plurality of the intensity measurement values.

In a preferred mode of the present invention, the population parameter extraction step includes a scale parameter extraction step of extracting a scale parameter of the plurality of intensity measurement values.

In a preferred mode of the present invention, the scale parameter extraction step is a step of extracting a full width at half maximum of the plurality of the intensity measurement values.

In a preferred mode of the present invention, the population parameter extraction step is a step of extracting a plurality of types of population parameters from the plurality of the intensity measurement values for one semiconductor substrate, and in the analysis step, the semiconductor substrate is analyzed on the basis of a combination of the plurality of types of population parameters.

In a preferred mode of the present invention, in the analysis step, the semiconductor substrate is analyzed on the basis of a combination of a location parameter and a scale parameter.

In a preferred mode of the present invention, the method further includes a classification step of classifying a plurality of semiconductor substrates on the basis of the combination of the location parameter and the scale parameter.

In a preferred mode of the present invention, the method further includes a classification criterion creation step of creating in advance a classification criterion for a feature of the subsurface damaged layer of the semiconductor substrate according to the combination of the location parameter and the scale parameter obtained through analysis of the plurality of the semiconductor substrates that are evaluation targets, in which the classification step includes a classification step of classifying the plurality of semiconductor substrates that are evaluation targets in light of the classification criterion on the basis of the combination of the location parameter and the scale parameter.

In a preferred mode of the present invention, the data acquisition step includes acquiring first scattered light intensity data and second scattered light intensity data in which each of a first intensity measurement value of scattered light measured by causing first laser light having first penetration characteristics to be incident and a second intensity measurement value of scattered light measured by causing second laser light having second penetration characteristics to be incident is associated with the measurement position information including planar directions of the semiconductor substrate, the statistic calculation step includes calculating a first statistic and a second statistic respectively from the first intensity measurement value and the second intensity measurement value associated with the measurement position information, the population parameter extraction step is a step of extracting a first population parameter and a second population parameter respectively from the calculated first statistic and second statistic, and the analysis step is a step of analyzing the semiconductor substrate on the basis of a combination of the first population parameter and the second population parameter.

In a preferred mode of the present invention, the first laser light is S-polarized light, and the second laser light is P-polarized light.

The method further includes a classification criterion creation step of creating in advance a classification criterion for a feature of the subsurface damaged layer of the semiconductor substrate according to the combination of the first population parameter and the second population parameter obtained through analysis of a plurality of semiconductor substrates that are evaluation targets, and the analysis step includes a classification step of classifying the plurality of semiconductor substrates that are evaluation targets in light of the classification criterion on the basis of the combination of the first population parameter and the second population parameter.

In a preferred mode of the present invention, the method further includes an evaluation step of evaluating the subsurface damaged layer on the basis of the intensity of scattered light obtained in the measurement step.

In a preferred mode of the present invention, the evaluation step includes a mapping step of creating a distribution diagram of statistics calculated on the basis of the intensity of the scattered light.

In a preferred mode of the present invention, the evaluation step includes a location parameter extraction step of extracting a location parameter of the statistic calculated on the basis of the intensity of the scattered light.

In a preferred mode of the present invention, the location parameter extraction step is a step of extracting a most frequent value.

In a preferred mode of the present invention, the evaluation step includes a scale parameter extraction step of extracting a scale parameter of the statistic calculated on the basis of the intensity of the scattered light.

In a preferred mode of the present invention, the scale parameter extraction step is a step of extracting a full width at half maximum.

The present invention to solve the above-described problems is a method for evaluating a subsurface damaged layer in which the subsurface damaged layer is evaluated on the basis of an intensity of scattered light generated in a boundary region between an oxide layer and a strained layer of a semiconductor substrate.

The present invention to solve the above-described problem is a method for evaluating a subsurface damaged layer in which the subsurface damaged layer is evaluated on the basis of an intensity of scattered light generated in a boundary region between a strained layer and a bulk layer of a semiconductor substrate.

The present invention to solve the above-described problem is a method for evaluating a subsurface damaged layer, the method including evaluating a subsurface damaged layer on the basis of an intensity of scattered light generated in a boundary region between an oxide layer and a strained layer of a semiconductor substrate and an intensity of scattered light generated in a boundary region between the strained layer and a bulk layer of the semiconductor substrate.

The present invention relates to a method for manufacturing a semiconductor substrate, including a step of evaluating the subsurface damaged layer of the semiconductor substrate by using any of the above evaluation methods or the above evaluation systems; a specifying step of specifying a layer including a predetermined amount of strain as a result of the evaluation; and a removal step of removing the specified layer.

### Advantageous Effects of Invention

According to the disclosed technology, it is possible to provide a novel technology capable of evaluating a subsurface damaged layer without destroying a semiconductor substrate.

According to the disclosed technology, it is possible to provide a novel technology capable of evaluating a distribution of a subsurface damaged layer at a high speed without destroying a semiconductor substrate.

Other problems, features, and advantages will become apparent by reading the following detailed description when taken in conjunction with the drawings and claims.

### Brief Description of Drawings

Fig. 1 is an explanatory diagram for describing an evaluation method according to an embodiment.
Fig. 2 is an explanatory diagram for describing the evaluation method according to the embodiment.
Fig. 3 is a block diagram of an inspection device used in the evaluation method according to the embodiment.
Fig. 4 is an explanatory diagram of a measurement step in the evaluation method according to the embodiment.
Fig. 5 is an explanatory diagram of an evaluation step in the evaluation method according to the embodiment.
Fig. 6 is an explanatory diagram of an evaluation step in the evaluation method according to the embodiment.
Fig. 7 is an explanatory diagram for describing a measurement result according to an Example.
Fig. 8 is an explanatory diagram for describing a measurement result according to an Example.
Fig. 9 is an explanatory diagram for describing an example of analysis according to an Example.
Fig. 10 is an explanatory diagram for describing an evaluation system according to the embodiment.
Fig. 11 is an explanatory diagram for describing the evaluation system according to the embodiment.

### Description of Embodiments

One aspect of the present invention is a method for evaluating a subsurface damaged layer of a semiconductor substrate. The method for evaluating the subsurface damaged layer is preferably a method for evaluating strain. The method for evaluating the subsurface damaged layer is more preferably a method for evaluating an amount of strain.

In the present invention, a subsurface damaged layer refers to a layer including alteration introduced by mechanical processing.

A detection target in the method for evaluating a subsurface damaged layer of the present invention is strain located under a surface of a semiconductor substrate. This strain is usually introduced by processing a semiconductor substrate. The strain that is a detection target may adversely affect a post-process of manufacturing a semiconductor device depending on its degree, and in general, the strain to an extent that may adversely affect a post-process of manufacturing a semiconductor device is located in a depth range of 1 um to 20 um, 1 um to 10 um, 1 um to 8 µm, and 1 um to 6 um under the surface of the semiconductor substrate. Therefore, in other words, a subsurface damaged layer and an inspection region in a depth direction in the evaluation method of the present invention are in depth ranges up to 20 µm, to 10 µm, to 8 µm, and to 6 um under the surface of the semiconductor substrate.

The strain refers to a deviation of an actual crystal lattice from a reference when an ideal crystal lattice is used as the reference. An amount of strain is a value indicating the degree thereof.

The method for evaluating a subsurface damaged layer of the present invention includes evaluating an amount of strain of a semiconductor substrate, a distribution thereof, or uniformity thereof.

That is, the method for evaluating a subsurface damaged layer of a semiconductor substrate according to the present invention is a method for evaluating an amount of strain including measurement of an amount of strain of a target substrate, visualization of a measured value, and analysis using the measured value.

Hereinafter, preferred embodiments of a method and a system for evaluating a subsurface damaged layer according to the present invention will be described in detail with reference to the accompanying drawings. The technical scope of the present invention is not limited to the embodiments illustrated in the accompanying drawings, and can be appropriately changed within the scope described in the claims. In the following description of the embodiment and the accompanying drawings, the same reference numerals are given to the same constituents, and redundant description is omitted.

### <<Method for evaluating subsurface damaged layer>>

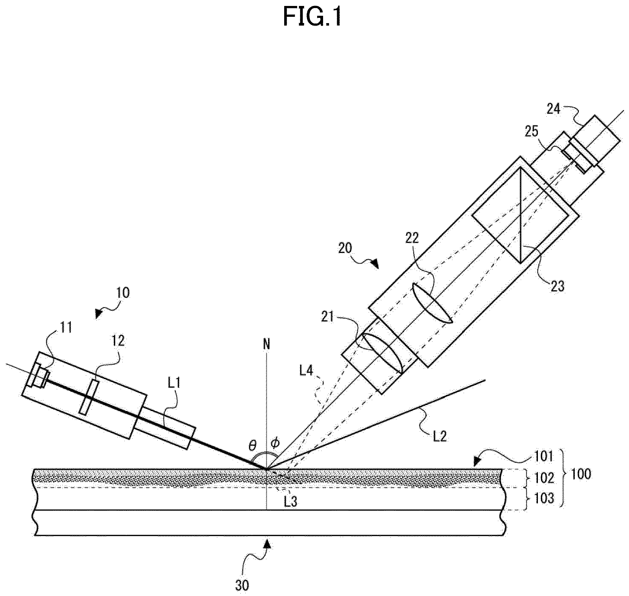

Fig. 1 is an explanatory diagram for describing a method for evaluating a subsurface damaged layer according to an embodiment.

The method for evaluating a subsurface damaged layer according to the present invention is characterized by evaluating a subsurface damaged layer 102 on the basis of an intensity of scattered light L4 that is scattered by the subsurface damaged layer 102 present under a surface 101. Specifically, laser light L1 emitted from a light projection system 10 is caused to be incident from a surface 101 of a semiconductor substrate 100 to the inside. Incident light L3 incident to the inside of the semiconductor substrate 100 is scattered at the subsurface damaged layer 102 to generate scattered light L4. The scattered light L4 is measured by a light receiving system 20, and the subsurface damaged layer 102 is evaluated on the basis of the intensity of the scattered light L4.

The scattered light L4 may include surface scattered light and internal scattered light. The surface scattered light may include scattered light derived from surface deposits, scattered light derived from surface irregularities, and scattered light derived from lattice defects. The internal scattered light may include scattered light derived from lattice defects and scattered light derived from internal strain.

A detection target in the method for evaluating a subsurface damaged layer of the present invention is scattered light derived from internal strain in the internal scattered light.

Thus, it is preferable that generation and/or detection of scattered light other than the detection target, that is, other than scattered light derived from internal strain, including scattered light derived from surface deposits, scattered light derived from surface irregularities, and scattered light derived from lattice defects, is suppressed by using an appropriate method.

However, the scattered light L4 may include scattered light other than a detection target within a range in which the intensity of scattered light derived from internal strain can be determined.

The semiconductor substrate 100 is a semiconductor material manufactured according to steps including at least one of a slicing step, a polishing step, and a grinding step. As the semiconductor substrate 100 manufactured through these steps, a silicon (Si) substrate may be exemplified. In the slicing step, the polishing step, and the grinding step described above, the subsurface damaged layer 102 that adversely affects device manufacturing may be introduced. In particular, recent research has revealed that the subsurface damaged layer 102 adversely affects a device in a compound semiconductor material classified as a material that is difficult to process.

The method for evaluating a subsurface damaged layer according to the present invention is suitable for evaluating the subsurface damaged layer 102 of a compoundsemiconductor material substrate such as a silicon carbide (SiC) substrate, a gallium nitride (GaN) substrate, an aluminum nitride (AlN) substrate, a gallium oxide (Ga₂O₃) substrate, or a sapphire substrate.

The semiconductor substrate 100 includes the surface 101 planarized through chemical mechanical polishing or the like, the subsurface damaged layer 102 introduced due to steps including machining such as a slicing step, a grinding step, and a polishing step, and a bulk layer 103. As illustrated in Fig. 1, the subsurface damaged layer 102 is a layer introduced under the surface 101 of the semiconductor substrate 100 and includes an oxide layer 1021 and a strained layer 1022.

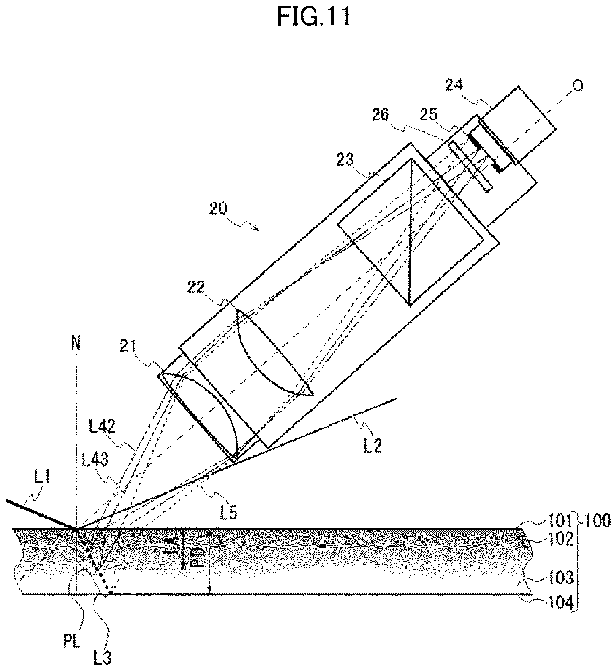

From another viewpoint, a layer and a boundary are not clearly separated under the surface 101 of the semiconductor substrate 100, and the subsurface damaged layer 102 in which the degree of strain decreases toward the inside is continuously distributed in a state in which a boundary with the bulk layer 103 is ambiguous (Fig. 11). In other words, there is also a viewpoint in which the subsurface damaged layer 102 is a concept indicating a layer having a relatively large amount of strain, and the bulk layer 103 is a concept indicating a layer having a relatively small or negligible amount of strain, and there is no boundary clearly separating the two.

The surface 101 is planarized through a planarization process such as chemical mechanical polishing. Quantitatively, the surface 101 includes a surface having an arithmetic average roughness (Ra) of 0.5 nm or less. Preferably, the surface 101 includes a surface having an arithmetic average roughness (Ra) of 0.4 nm or less, 0.3 nm or less, or 0.2 nm or less.

The laser light L1 is incident into the inside from the surface 101 of the semiconductor substrate 100. That is, the surface 101 is a boundary surface to which the laser light L1 is incident.

Therefore, since the semiconductor substrate 100 has the surface 101 planarized through the planarization process, scattered light due to irregularities of the surface 101 is less likely to be generated, or the intensity of scattered light generated on the surface 101 is reduced. As a result, in the scattered light L4, a ratio of scattered light generated in the subsurface damaged layer 102 under the surface 101 increases.

The surface 101 of the semiconductor substrate 100 is planarized to such an extent that at least scattered light generated on the surface 101 does not hinder detection of scattered light generated in the subsurface damaged layer 102, and thus the strain of the subsurface damaged layer 102 can be evaluated on the basis of a threshold value or mapping.

In other words, the planarized surface 101 has an effect of suppressing generation of scattered light derived from surface irregularities or reducing the intensity of scattered light derived from surface irregularities. As a result, in the scattered light L4, a ratio of scattered light derived from surface irregularities that is not a detection target can be reduced.

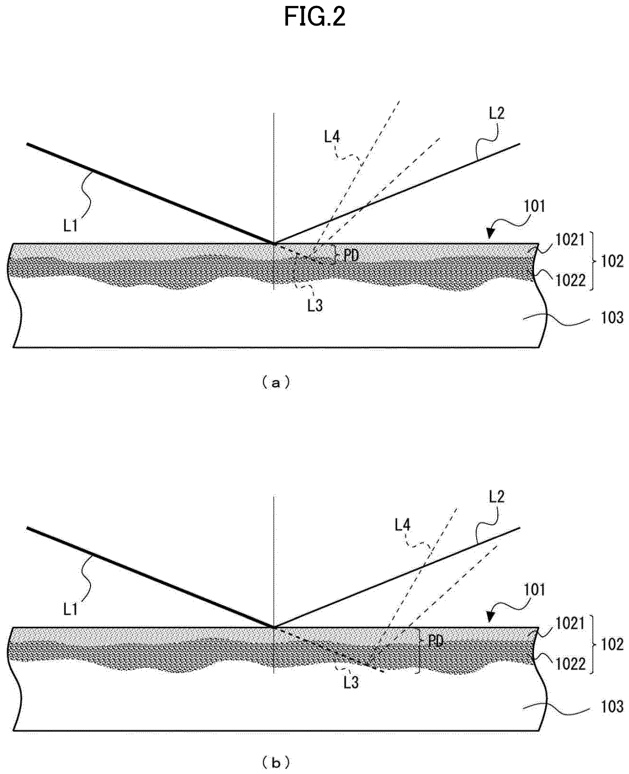

Fig. 2 is an explanatory diagram for describing a relationship between polarized light of the laser light L1 and the subsurface damaged layer 102. Fig. 2(a) is an explanatory diagram for describing a case where the semiconductor substrate 100 is irradiated with the S-polarized laser light L1. Fig. 2(b) is an explanatory diagram for describing a case where the semiconductor substrate 100 is irradiated with the P-polarized laser light L1.

The method for evaluating a subsurface damaged layer according to the present invention includes a measurement step using S-polarized light in which the S-polarized laser light L1 is caused to be incident from the surface 101 of the semiconductor substrate 100 having the subsurface damaged layer 102 and the intensity of scattered light L4 scattered under the surface 101 is measured (refer to Fig. 2(a)). In the S-polarized light, an electric field of the laser light L1 oscillates in a direction perpendicular to the incidence surface, and thus the transmittance thereof is lower than that of the P-polarized light applied under the same conditions. Thus, in consideration of a total amount of the incident light L3, the energy, and the like, the S-polarized light tends to be used to detect scattered light generated in a relatively shallow portion compared with the P-polarized light. Therefore, the S-polarized light is suitable for measuring strain of a shallow portion of the subsurface damaged layer 102.

Specifically, the S-polarized light is suitable for measuring strain located in a depth range from the substrate surface to 10 µm, to 8 µm, to 6 µm, or to 4 um.

In a case where the S-polarized laser light L1 is used, it is considered that the scattered light L4 is generated in a boundary region between the oxide layer 1021 closer to the surface 101 and the strained layer 1022.

That is, the method for evaluating a subsurface damaged layer according to the present invention is considered to be a method for evaluating the subsurface damaged layer 102 on the basis of the intensity of the scattered light L4 generated in the boundary region between the oxide layer 1021 and the strained layer 1022. The boundary region here includes an interface between the oxide layer 1021 and the strained layer 1022.

From another viewpoint, the method for evaluating a subsurface damaged layer according to the present invention is a method for evaluating the subsurface damaged layer 102 on the basis of the intensity of scattered light L4 generated in a depth range of about 10 um under the surface 101 in a case where the S-polarized laser light L1 is incident from the surface 101 of the semiconductor substrate 100 having the subsurface damaged layer 102.

The method for evaluating a subsurface damaged layer according to the present invention includes a measurement step using P-polarized light in which the P-polarized laser light L1 is caused to be incident from the surface 101 of the semiconductor substrate 100 and the intensity of the scattered light L4 scattered under the surface 101 is measured (refer to Fig. 2(b)). In the P-polarized light, an electric field of the laser light L1 oscillates in a direction parallel to the incidence surface, and thus the transmittance thereof is higher than that of the S-polarized light applied under the same conditions. Thus, in consideration of a total amount of the incident light L3, the energy, and the like, the P-polarized light tends to be used to detect scattered light generated in a relatively deep portion compared with the S-polarized light. Therefore, the P-polarized light is suitable for measuring strain of a deep portion of the subsurface damaged layer 102.

Specifically, the P-polarized light is suitable for measuring strain located in a range from the substrate surface to 47 µm, to 30 µm, to 20 um, or to 10 um.

In a case where the P-polarized laser light L1 is used, it is considered that the scattered light L4 is generated in a boundary region between the strained layer 1022 present below the oxide layer 1021 and the bulk layer 103.

That is, the method for evaluating a subsurface damaged layer according to the present invention is considered to be a method for evaluating the subsurface damaged layer 102 on the basis of the intensity of the scattered light L4 generated in the boundary region between the strained layer 1022 and the bulk layer 103. The boundary region here includes an interface between the strained layer 1022 and the bulk layer 103.

From another viewpoint, the method for evaluating a subsurface damaged layer according to the present invention is a method for evaluating the subsurface damaged layer 102 on the basis of the intensity of the scattered light L4 generated in a depth range of about 47 um under the surface 101 in a case where the P-polarized laser light L1 is incident from the surface 101 of the semiconductor substrate 100 having the subsurface damaged layer 102.

An inspection region IA in the depth direction in the case of using the S-polarized laser light L1 may be adjusted to be included in a depth range from the substrate surface to 10 µm, to 8 µm, to 6 µm, or to 4 um.

The inspection region IA in the depth direction in the case of using the P-polarized laser light L1 may be adjusted to be included in a depth range from the substrate surface to 47 µm, to 30 µm, to 20 um, or to 10 µm.

The inspection region IA in the depth direction in the case of using the laser light L1 changes according to penetration characteristics including polarization characteristics or wavelength characteristics of the laser light L1, an incident angle to the semiconductor substrate 100, and the like.

That is, the inspection region IA in the depth direction in a case of using the laser light L1 can be adjusted by adjusting the penetration characteristics of the laser light L1.

The method for evaluating a subsurface damaged layer according to the present invention includes an evaluation step of evaluating the subsurface damaged layer 102 on the basis of the result of the intensity of the scattered light L4 obtained in the measurement step described above. This evaluation step is, for example, a step of evaluating the subsurface damaged layer 102 by calculating a statistic from the intensity of the scattered light L4 obtained in the measurement using the S-polarized light and/or the P-polarized light, and visualizing and quantifying the statistic.

The method for evaluating a subsurface damaged layer according to the embodiment may include a cleaning step S10 of cleaning the surface of the semiconductor substrate 100, a measurement step S20 of measuring the intensity of the scattered light L4 scattered by causing the laser light L1 to be incident to the subsurface damaged layer 102 of the semiconductor substrate 100, and an evaluation step S30 of evaluating the subsurface damaged layer 102 on the basis of the intensity of the scattered light L4.

Hereinafter, each step will be described in detail according to an embodiment of the present invention.

### <Cleaning step S10>

The cleaning step S10 is a step of eliminating a factor of scattering of the laser light L1 on the surface 101 of the semiconductor substrate 100 due to organic matter contamination, particle contamination, an oxide layer, ion contamination, or the like adhering to the surface of the semiconductor substrate 100. In particular, in a case where particles adhere to the surface of the semiconductor substrate 100, scattering stronger than the scattered light L4 generated in the subsurface damaged layer 102 occurs. Thus, it is desirable that particle contamination or the like is removed before measurement on the subsurface damaged layer 102 is performed.

In other words, the cleaning step S10 has an effect of suppressing generation of scattered light derived from surface deposits or reducing the intensity of scattered light derived from surface deposits. As a result, in the scattered light L4, a ratio of scattered light derived from surface deposits that is not a detection target can be reduced.

As a method of the cleaning step S10, any method capable of removing at least one of organic matter contamination, particle contamination, an oxide layer, and ion contamination adhering to the surface 101 of the semiconductor substrate 100 may be employed. For example, chemical cleaning such as general RCA cleaning (NH₄OH, H₂O₂, or H₂O) or acid cleaning (HCl or HF), or physical cleaning using bubbles or brushes may be employed. Any method capable of cleaning the surface 101 of the semiconductor substrate 100 may be naturally employed.

The cleaning step S10 according to the embodiment has been described above. The method for evaluating a subsurface damaged layer according to the present invention may also employ an exemplary mode of not including the cleaning step S10. That is, in a case where the surface 101 of the semiconductor substrate 100 is sufficiently clean, the subsurface damaged layer 102 may be evaluated by including the measurement step S20 and the evaluation step S30 that will be described later without performing the cleaning step S10.

### <Measurement step S20>

As illustrated in Fig. 1, the measurement step S20 is a step in which the incident light L3 emitted from the light projection system 10 of the evaluation system and incident from the surface 101 of the semiconductor substrate 100 is scattered inside the subsurface damaged layer 102 and the scattered light L4 that is scattered is measured by the light receiving system 20. Therefore, it is desirable that the surface 101 of the semiconductor substrate 100 is sufficiently planarized through chemical mechanical polishing or the like. In other words, it is desirable that the measurement step S20 is performed on the surface 101 after chemical mechanical polishing.

The measurement step S20 according to the present embodiment is a step of causing the laser light L1 to be incident at an incident angle θ inclined with respect to a normal line N of the surface 101 of the semiconductor substrate 100. A part of the laser light L1 emitted from the light projection system 10 at the incident angle θ is specularly reflected by the surface 101 of the semiconductor substrate 100 to become the reflected light L2, and a part thereof is incident to the inside of the semiconductor substrate 100 to become the incident light L3. The incident light L3 is scattered by the subsurface damaged layer 102 to generate the scattered light L4.

The reflected light L2 is specularly reflected at the same angle as the incident angle θ of the laser light L1, and has higher intensity than the scattered light L4. The present invention is a method for evaluating the subsurface damaged layer 102 on the basis of the intensity of the scattered light L4. Thus, in order to accurately measure the scattered light L4, it is necessary to suppress the reflected light L2 from entering the light receiving sensor 24. For example, a method of disposing the light receiving system 20 to avoid the reflected light L2 or a method of restricting light entering the light receiving sensor 24 by disposing a light shielding tape on an optical path of the reflected light L2 may be employed.

The scattered light L4 measured in the present invention includes elastic scattering. That is, by measuring the scattered light L4 including elastic scattering having a higher intensity than that of inelastic scattering, a measurement sensitivity can be improved, and high-speed measurement can be realized.

The measurement step S20 may include a measurement step S21 using S-polarized light and a measurement step S22 using P-polarized light. Since the detectability of generated scattered light varies depending on a generation depth of the scattered light in the S-polarized light and the P-polarized light, a measurement region of the subsurface damaged layer 102 can be changed by selecting polarized light of the laser light L1. That is, in the measurement step S21 using the S-polarized light, it is considered that the scattered light L4 of the subsurface damaged layer 102 near the surface 101 can be measured. On the other hand, in the measurement step S22 using P-polarized light, it is considered that the scattered light L4 of the subsurface damaged layer 102 near the bulk layer 103 can be measured.

Regarding control of a penetration depth PD of the laser light L1 into the semiconductor substrate 100, an appropriate incident angle θ can be naturally selected according to the physical properties of the semiconductor substrate 100 that is a measurement target and a thickness of the subsurface damaged layer 102.

Here, the incident angle θ of the laser light L1 preferably satisfies 40° ≤ θ, 45° ≤ θ, or 50° ≤ θ at a lower limit thereof, and θ ≤ 80°, θ ≤ 75°, or θ ≤ 70° at an upper limit thereof.

In a case where the incident angle θ is in the vicinity of the Brewster's angle (Brewster's angle ± about 10°) of the semiconductor substrate 100, P-polarized light penetrates deeper into the semiconductor substrate 100, and strain of a deep portion under the surface can be detected, which is more preferable.

The evaluation system used for evaluating a subsurface damaged layer according to the embodiment can be naturally employed as long as it has a device configuration capable of causing the laser light L1 to be incident to the semiconductor substrate 100 and measuring the intensity of the scattered light L4 scattered at the subsurface damaged layer 102.

Hereinafter, an example of an evaluation system used in the embodiment will be described with reference to Figs. 1 to 4.

### (First embodiment of evaluation system)

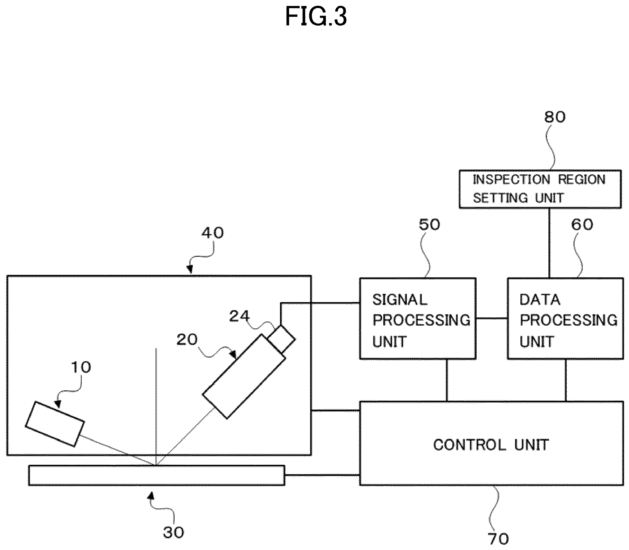

Fig. 3 is a block diagram of an evaluation system used in the evaluation method according to the embodiment.

The evaluation system according to the embodiment includes a light projection system 10 that emits laser light L1, a light receiving system 20 that receives scattered light L4, a stage 30 on which a semiconductor substrate 100 that is a measurement target is installed, a housing 40 on which the light projection system 10 and the light receiving system 20 are installed, a signal processing unit 50 that performs signal processing on a signal measured by the light receiving system 20, a data processing unit 60 that performs data processing, and a control unit 70 that performs various types of control.

In other words, the evaluation system according to the embodiment includes the stage 30 capable of holding the semiconductor substrate 100 that is a measurement target, the light projection system 10 capable of emitting the S-polarized and/or P-polarized laser light L1, the light receiving system 20 capable of receiving the scattered light L4 scattered under the surface 101 of the semiconductor substrate 100, and the data processing unit 60 that evaluates the subsurface damaged layer 102 on the basis of an intensity of the scattered light L4 measured by using the S-polarized light and the P-polarized light.

The light projection system 10 includes a laser output unit 11 and a wavelength plate 12. The light projection system 10 is attached to the housing 40 such that the laser light L1 is incident at the incident angle θ inclined with respect to the normal line N of the surface of the semiconductor substrate 100.

Note that the light projection system 10 may be attached to the housing 40 such that the incident angle θ can be adjusted.

The laser output unit 11 is a generation source of the laser light L1, and for example, a gas laser such as a He-Ne laser or a solid laser such as a semiconductor laser and a YAG laser may be employed.

The wavelength plate 12 performs adjustment such as wavelength separation, fine adjustment, ellipticity adjustment and polarization rotation on the laser light L1 generated by the laser output unit 11. In the wavelength plate 12, the S-polarized light and the P-polarized light of the laser light L1 can be switched, and the penetration characteristics of the laser light L1 can be controlled without changing measurement conditions such as the incident angle θ and a wavelength λ. An appropriate material or configuration of the wavelength plate 12 is selected according to a material or a condition of the semiconductor substrate 100 that is a measurement target.

That is, the wavelength plate 12 is an aspect of an optical adjuster that performs adjustment such as wavelength separation, fine adjustment, ellipticity adjustment, and polarization rotation on the laser light L1 to control the penetration characteristics of the laser light L1.

By controlling the penetration characteristics of the laser light L1 with the optical adjuster, the evaluation system can adjust the penetration depth PD of the incident light L3 and/or the inspection region IA in the depth direction to selectively detect strain located in any depth range of the semiconductor substrate 100.

As the optical adjuster, various optical elements (a filter, a lens, a mirror, and the like) or combinations thereof not limited to the wavelength plate 12 may be used, and penetration characteristics (polarization characteristics, a wavelength, an incident angle, and the like) of the laser light L1 may be adjusted.

A wavelength of the laser light L1 provides an intensity at which the scattered light L4 can be detected in the light receiving system 20, and thus desirably has a photon energy larger than a bandgap of the semiconductor substrate 100. That is, the wavelength λ of the laser light L1 desirably satisfies a relational expression of "λ [nm] ≤ 1239.8/bandgap [eV]".

Specifically, in a case where a measurement target is 4H-SiC, it is desirable to set the wavelength to 380 nm or less (λ [nm] ≤ 1239.8/3.26 [eV]). In a case where the measurement target is GaN, the wavelength is desirably set to 365 nm or less (λ [nm] ≤ 1239.8/3.39 [eV]).

A lower limit value of the photon energy of the laser light L1 is preferably 101% of the bandgap of the semiconductor substrate 100, more preferably 1030 of the bandgap, still more preferably 1050 of the bandgap, and still more preferably 1070 of the bandgap.

An upper limit value of the photon energy of the laser light L1 is preferably 1220 of the bandgap of the semiconductor substrate 100, more preferably 120% of the bandgap, still more preferably 1150 of the bandgap, still more preferably 1120 of the bandgap, and still more preferably 1100 of the bandgap.

The laser light L1 having a photon energy defined by the range of the lower limit value and the upper limit value described above penetrates the subsurface damaged layer, particularly a range including strain that is an evaluation target, in a state in which sufficient energy is held, and generates scattered light caused by the subsurface damaged layer, particularly the strain, with detectable intensity.

A relationship between a wavelength of the laser light L1 (photon energy of the laser light L1) and a depth at which strain can be detected can be calculated, for example, by considering the absorption coefficient disclosed in "Penetration depths in the ultraviolet for 4H, 6H and 3C silicon carbide at seven common laser pumping wavelengths" (S. G Sridhara, T. J Eperjesi, R. P Devaty, W. J Choyke, Materials Science and Engineering: B Volumes 61-62, 30 July 1999, Pages 229 to 233).

For example, in a case where the laser light L1 has a photon energy of 122% of the bandgap of 4H-SiC (in a case where the wavelength of the laser light L1 is 313 nm), a depth at which the strain can be detected can be estimated to be about 4 um.

For example, in a case where the laser light L1 has a photon energy of 112% of the bandgap of 4H-SiC (in a case where the wavelength of the laser light L1 is 340 nm), a depth at which the strain can be detected can be estimated to be about 16 um.

For example, in a case where the laser light L1 has a photon energy of 1070 of the bandgap of 4H-SiC (in a case where the wavelength of the laser light L1 is 355 nm), a depth at which the strain can be detected can be estimated to be about 50 µm.

The intensity of the laser light L1 is desirably set to an intensity at which the laser light L1 is not transmitted through the semiconductor substrate 100. That is, it is desirable that the penetration depth PD of the incident light L3 is set to be equal to or less than the thickness of the semiconductor substrate 100.

The light receiving system 20 includes an objective lens 21, an imaging lens 22, a beam splitter 23, a light receiving sensor 24, and a slit 25. The light receiving system 20 is desirably attached to the housing 40 at a measurement angle ϕ different from the incident angle θ such that the reflected light L2 does not enter the light receiving system 20.

The measurement angle ϕ of the light receiving system 20 preferably satisfies 20° ≤ ϕ, 25° ≤ ϕ, or 30° ≤ ϕ at the lower limit, and satisfies ϕ ≤ 70°, ϕ ≤ 65°, or ϕ ≤ 60° at the upper limit.

Such a measurement angle ϕ makes it difficult for scattered light generated in a shallow portion near the surface 101 of the semiconductor substrate 100 to enter the light receiving system 20, so that strain under the surface 101 can be accurately detected.

The light receiving system 20 may be attached to the housing 40 such that the measurement angle ϕ can be adjusted.

The beam splitter 23 is desirably a cube beam splitter. The light receiving sensor 24 may be configured to be able to convert the intensity of the scattered light L4 into an electric signal. For example, a photomultiplier tube, a photodiode, or the like may be employed. The slit 25 is disposed to determine an inspection region of the laser light L1.

Here, the inspection region of the laser light L1 is determined from any depth range under the surface 101 of the semiconductor substrate 100 within the range of the penetration depth PD of the incident light L3.

That is, the slit 25 is an aspect of a light selector that selectively causes the scattered light L4 generated in the inspection region among pieces of scattered light generated under the surface 101 of the semiconductor substrate 100 to enter the light receiving sensor 24.

In other words, the slit 25 is an aspect of a light selector that shields scattered light generated in a non-inspection region (a portion shallower or a portion deeper than the inspection region, a deep portion, a back surface, or the like in the semiconductor substrate 100) deviating from the inspection region among pieces of scattered light generated under the surface 101 of the semiconductor substrate 100 not to allow the scattered light to enter the light receiving sensor 24.

The incident light L3 and the scattered light L4 are attenuated more deeply under the surface 101 of the semiconductor substrate 100. Therefore, the light selector shields the scattered light generated in the non-inspection region deviating from the inspection region, and thus the scattered light L4 generated in the inspection region can be selectively detected.

This also has an effect of reducing a detection intensity of scattered light derived from surface irregularities. As a result, in the scattered light L4, a ratio of scattered light derived from surface irregularities that is not a detection target can be reduced.

As the light selector, various optical elements (a filter, a lens, a mirror, and the like) or combinations thereof not limited to the slit 25 may be used.

### (Second embodiment of evaluation system)

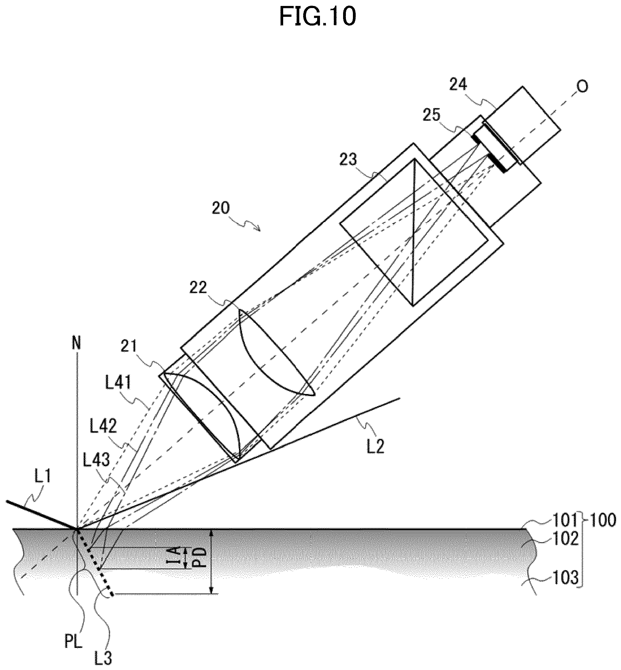

Here, another example of the light receiving system 20 and details of light selection will be described with reference to Fig. 10.

As illustrated in Fig. 11, the light receiving system 20 includes an objective lens 21, an imaging lens 22, a beam splitter 23, a light receiving sensor 24, and a slit 25.

The laser light L1 is refracted by the surface 101 of the semiconductor substrate 100, and penetrates up to a length corresponding to a penetration length PL while repeating scattering and attenuation (incident light L3). In this case, a distance from the surface 101 of the deepest portion where the incident light L3 has reached is the penetration depth PD.

Due to the incidence of the laser light L1, scattered light including surface scattered light L41 scattered on the surface 101, scattered light L42 scattered at a shallow portion of the subsurface damaged layer 102, and scattered light L43 scattered at a deep portion of the subsurface damaged layer 102 may be generated.

Each of the pieces of scattered light L41, L42, and L43 passes through the objective lens 21 and the imaging lens 22 and reaches the slit 25.

The slit 25 is disposed to be shifted (offset) with respect to an optical axis O in order to shield scattered light scattered on the optical axis O. In this example, the slit 25 shields the surface scattered light L41 such that the surface scattered light L41 does not reach the light receiving sensor 24.

The slit 25 is disposed at a position and/or with a width to shield scattered light generated in a portion shallower than the scattered light L42. The slit 25 is disposed at a position and/or with a width that shields scattered light generated in a portion deeper than the scattered light L43.

That is, in this example, by adjusting the position and/or the width of the slit 25, a depth range including generation locations of the pieces of scattered light L42 and L43 is set in the inspection region IA, and the scattered light generated in this range can selectively reach the light receiving sensor 24.

The objective lens 21 and the imaging lens 22 widen an interval between the arrival points of the scattered light L42 and the scattered light L43 on the slit 25 side perpendicularly to the slit 25.

In other words, since the objective lens 21 and the imaging lens 22 can further narrow the inspection region IA, highly accurate measurement can be performed.

The magnification of the objective lens 21 and the imaging lens 22 is preferably about 1 to 100 times in total, and particularly preferably about 10 times.

As described above, the light selector may be any one that can selectively allow the scattered light L4 generated in a specific depth range to enter the light receiving sensor 24.

In the case of the slit 25, a position of the inspection region IA in the depth direction can be adjusted by adjusting a position of the slit 25. In this case, a position of the light receiving sensor 24 may also be adjusted in accordance with the position of the slit 25. In the case of the slit 25, a width of the inspection region IA can be adjusted by adjusting the width of the slit 25.

That is, by adjusting the light selector, it is possible to selectively detect strain located in any depth range under the surface 101 of the semiconductor substrate 100 within the range of the penetration depth PD of the incident light L3.

Since the penetration depth PD of the incident light L3 can be changed by changing the penetration characteristics (the polarization characteristics, the wavelength, the incident angle θ, and the like) of the laser light L1, a position or a width of the inspection region IA can be freely adjusted by adjusting and freely combining penetration characteristics of the laser light L1 and light reception conditions (a detection angle, a position or a width of the slit 25, magnifications of the objective lens 21 and the imaging lens 22, and the like).

### (Third embodiment of evaluation system)

Here, still another example of the light receiving system 20 will be described with reference to Fig. 11.

In this example, a case is considered in which the incident light L3 reaches a back surface 104 of the semiconductor substrate 100.

In this example, the slit 25 is provided at a position and with a width to shield scattered light (or reflected light) generated at a position deeper than the scattered light L43.

In particular, the slit 25 shields the light L5 generated due to reflection or scattering of the incident light L3 on the back surface 104 such that the light L5 does not reach the light receiving sensor 24.

On the other hand, in this example, the slit 25 is provided at a position and with a width not to shield scattered light generated at a position shallower than the scattered light L42.

That is, the surface scattered light L41 and the like described with reference to Fig. 11 reach the light receiving sensor 24.

However, since the detection intensity of the surface scattered light L41 can be suppressed by eliminating the generation factor of the surface scattered light L41 as much as possible through the cleaning step or the planarization step of the substrate surface, it is possible to detect an intensity of internal scattered light such as the scattered light L42 or L43 such that the scattered light can be determined.

The light receiving system 20 preferably includes a bandpass filter 26 corresponding to the wavelength of the laser light L1.

The bandpass filter 26 enables the light receiving system 20 to selectively detect scattered light mainly caused by elastic scattering.

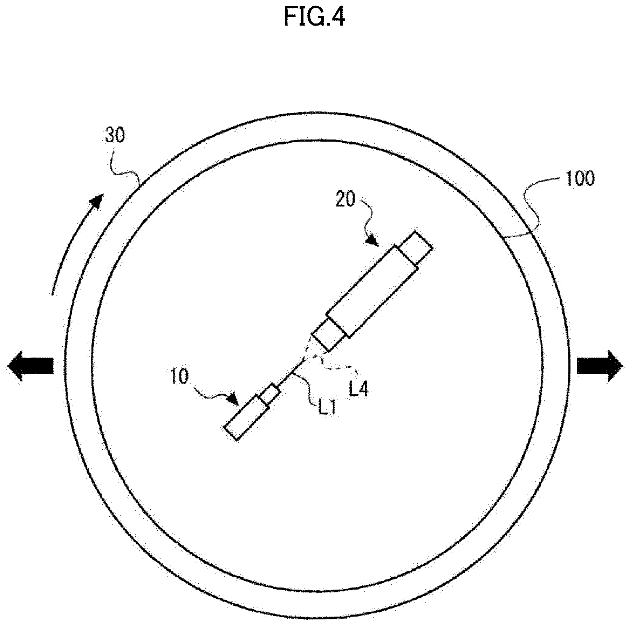

Fig. 4 is an explanatory diagram of the measurement step S20 in the evaluation method according to the embodiment.

As illustrated in Fig. 4, the stage 30 is provided with the semiconductor substrate 100 that is a measurement target, and is configured to be horizontally rotatable about the center of the semiconductor substrate 100. The stage 30 is configured to be able to translate parallelly the semiconductor substrate 100 with respect to the housing 40 (the light projection system 10 and the light receiving system 20). As described above, by translating parallelly the semiconductor substrate 100 while rotating the semiconductor substrate 100, a wide range (or the entire surface) of the semiconductor substrate 100 can be scanned with the laser light L1.

Although the mode in which the stage 30 is moved has been described, the semiconductor substrate 100 may be scanned with the laser light L1 by moving the light projection system 10 and the light receiving system 20.

The data processing unit 60 acquires information regarding the inspection region in the depth direction (measurement position information in the depth direction) from the inspection region setting unit 80 (inspection region information acquisition step), and acquires, on the basis of this, data including light projection conditions (penetration characteristics of the laser light L1 and the like) and/or light reception conditions (a detection angle, a position and a width of the slit 25, magnifications of the objective lens 21 and the imaging lens 22, and the like) under which the laser light L1 penetrates into the inspection region (light projection condition acquisition step) .

Alternatively, a user may input information regarding the inspection region in the depth direction (measurement position information in the depth direction) in advance for the inspection region setting unit 80, and thus the data processing unit 60 may acquire data including the light projection conditions and/or the light reception conditions on the basis of the data.

The control unit 70 acquires data including the light projection conditions and/or the light reception conditions from the data processing unit 60, and controls each constituent of the evaluation system including the light projection system 10, the light receiving system 20, and the stage 30 such that the laser light L1 penetrates into the inspection region and the scattered light generated in the inspection region is selectively measured (light selection step) on the basis of the data.

The signal processing unit 50 amplifies an electric signal (analog signal) measured by the light receiving sensor 24 (photomultiplier tube) and then converts the signal into a digital signal. The signal processing unit 50 acquires position information in the planar directions of the semiconductor substrate 100 from encoder information of the stage 30, and associates intensity information (intensity measurement value) of the scattered light L4 with the position information.

The data processing unit 60 acquires, from the signal processing unit 50, scattered light intensity data including a plurality of pieces of intensity information (intensity measurement values) of the scattered light L4 and measurement position information associated with each of the plurality of pieces of intensity information (intensity measurement values) as results of processing signals obtained by scanning the semiconductor substrate 100 with the laser light L1.

The intensity information (intensity measurement value) is an intensity measurement value of scattered light measured at a certain measurement position, and is indicated by one numerical value.

The measurement position information includes position information of the semiconductor substrate 100 in the planar directions (XY plane direction) and position information in the depth direction (Z direction).

In the measurement position information, the position information in the depth direction is determined on the basis of the light projection conditions and the light reception conditions.

On the basis of the data acquired from the signal processing unit 50, the data processing unit 60 performs data processing for classifying the data according to the intensity of the scattered light L4 and producing a distribution diagram or a histogram of the subsurface damaged layer 102. The control unit 70 controls laser light irradiation or scanning.

The data processing unit 60 and the control unit 70, for example, desirably employ a hardware configuration such as a processor and a storage, and are configured to be able to communicate with constituents including the light projection system 10, the light receiving system 20, the stage 30, the signal processing unit 50, and the inspection region setting unit 80 via a local region network or the like.

### <First embodiment of evaluation step>

Hereinafter, a first embodiment of the evaluation step will be described.

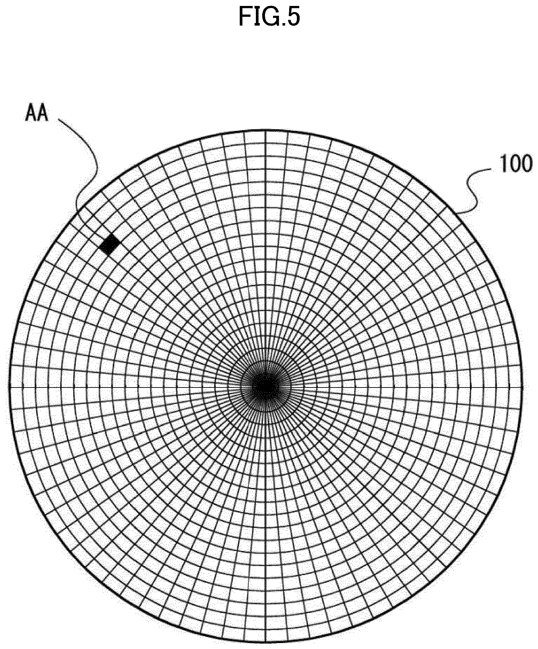

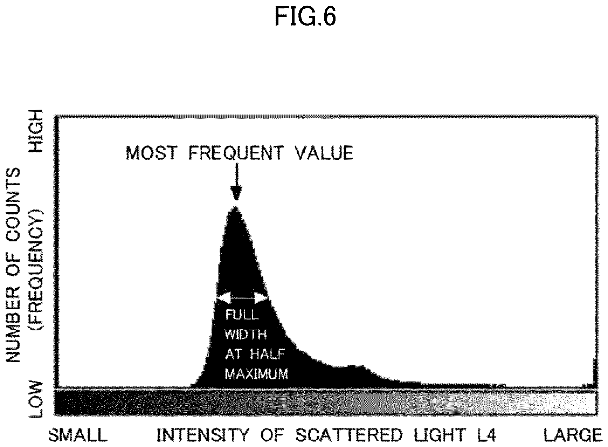

Figs. 5 and 6 are explanatory diagrams of the evaluation step S30 in the evaluation method according to the embodiment.

The evaluation step S30 is a step of evaluating the subsurface damaged layer 102 of the semiconductor substrate 100 from the intensity of the scattered light L4 obtained in the measurement step S20. Specifically, the evaluation step S30 is a step of setting a certain region AA in the semiconductor substrate 100 and calculating a statistic on the basis of the intensity of the scattered light L4 for each certain region AA to ascertain an amount of strain or a distribution status of the subsurface damaged layer 102 introduced into the semiconductor substrate 100.

The evaluation step S30 may include a region setting step S31 of setting the certain region AA obtained by partitioning the semiconductor substrate 100 by any area, a statistic calculation step S32 of calculating a statistic on the basis of the intensity of the scattered light L4 for each certain region AA, a threshold value setting step S33 of setting a threshold value for determining the quality of the subsurface damaged layer 102, a mapping step S34 of mapping the statistic in the certain region AA, and an analysis step S35 of analyzing the subsurface damaged layer 102 by using the statistic.

The region setting step S31 is a step of setting the certain region AA by dividing the measurement data measured in the measurement step S20 into a plurality of sections. In Fig. 5, the certain region AA having a fan shape is set on the concentric circle, but for example, may be set in any shape/area such as a lattice shape or a spiral shape.

The statistic calculation step S32 is a step of calculating a statistic such as an average value, a median value, or a most frequent value of the intensity of the scattered light L4 for each set certain region AA. For example, in a case where an average value is employed as the statistic, an integration step S321 of integrating the intensity of the scattered light L4 in the certain region AA and a division step S322 of dividing an integrated value obtained in the integration step S321 by the number of pieces of acquired data in a certain region of the certain region AA are included.

The integration step S321 is a step of calculating an integrated value of the scattered light L4 in the set certain region AA from the intensity information (intensity measurement value) and the position information of the scattered light L4 associated by the signal processing unit 50.

The division step S322 is a step of obtaining an average value of the set certain region AA range by dividing the integrated value obtained in the integration step S321 by the number of pieces of acquired data in a certain region of the certain region AA.

The threshold value setting step S33 is a step of setting a threshold value for extracting an unsuitable subsurface damaged layer 102 that adversely affects device manufacturing. Note that a plurality of the threshold values may be set, and for example, threshold values obtained by equally dividing the statistic from a lower limit value to an upper limit value into 256 may be provided such that a level of the statistic can be expressed by monochrome or color gradation.

The mapping step S34 is a step of creating a distribution diagram for visualizing a distribution status of the strain of the subsurface damaged layer 102. For example, in a case where a threshold value obtained by equally dividing the statistic from the lower limit value to the upper limit value into 256 is set, a contour diagram for visualizing an amount of strain and a distribution status of the subsurface damaged layer 102 can be created, and a region where the subsurface damaged layer 102 suitable for device manufacturing is distributed and a region where the subsurface damaged layer 102 unsuitable for device manufacturing is distributed can be visually distinguished.

The analysis step S35 is a step of analyzing the quality of the subsurface damaged layer 102 by using the result obtained in the measurement step S20. The analysis step S35 may include a location parameter extraction step S351 of extracting a location parameter (including, for example, one or more values selected from an average (arithmetic/geometric/harmonic), a median (quantile/order statistic), a most frequent value, and a class value) of the distribution of the statistic at the threshold value set in the threshold value setting step S33, a scale parameter extraction step S352 of extracting a statistical scale parameter (including, for example, one or more selected from a variance, a deviation value, a standard deviation, a mean deviation, a median absolute deviation, a range, and a full width at half maximum) of the distribution, and a classification step S353 of classifying the quality of the subsurface damaged layer 102 on the basis of the result of the location parameter extraction step S351 and/or the scale parameter extraction step S352.

Fig. 6 is an explanatory diagram for describing an example of the analysis step S35 according to the embodiment, and is a histogram in which the horizontal axis represents an intensity of the scattered light L4 and the vertical axis represents the number of counts (frequency).

The location parameter extraction step S351 is, for example, a step of extracting the intensity (most frequent value) of the scattered light L4 having the highest frequency in the subsurface damaged layer 102 from among the intensities of the scattered light L4 measured in the measurement step S20. As the most frequent value, a value having the largest number of counts in the histogram of Fig. 6 may be employed. By extracting this most frequent value, the measured quality of the subsurface damaged layer 102 can be quantified, and it is possible to ascertain an amount of contained strain compared with other semiconductor substrates.

The scale parameter extraction step S352 is, for example, a step of extracting a full width at half maximum of a chevron function having a most frequent value as a vertex in the histogram of Fig. 6. By extracting the full width at half maximum, a variation in the subsurface damaged layer 102 of the semiconductor substrate 100 subjected to measurement can be quantified, and it is possible to ascertain the degree of variation in the amount of strain compared with other semiconductor substrates.

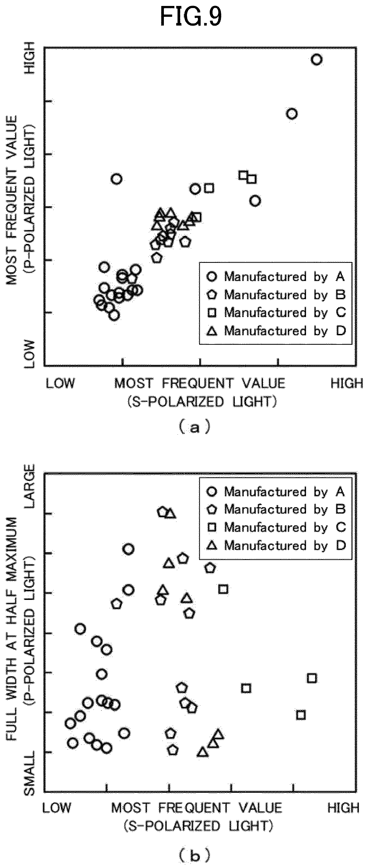

The classification step S353 is a step of classifying the subsurface damaged layer 102 on the basis of the extraction result in the location parameter extraction step S351 and/or the scale parameter extraction step S352. For example, the quality of the subsurface damaged layer 102 of the semiconductor substrate 100 subjected to measurement can be classified by plotting the most frequent value obtained in the measurement using the S-polarized laser light L1, the full width at half maximum obtained in the measurement using the S-polarized laser light L1, the most frequent value obtained in the measurement using the P-polarized laser light L1, and the full width at half maximum obtained in the measurement using the P-polarized laser light L1 on a graph in any combination (refer to Fig. 9).

Note that the evaluation step S30 according to the embodiment may employ a configuration of causing a processor of a computer to execute the region setting step S31, the statistic calculation step S32, the threshold value setting step S33, the mapping step S34, and the analysis step S35.

According to the method for evaluating a subsurface damaged layer according to the present invention, the subsurface damaged layer 102 can be evaluated in a non-destructive manner by making the laser light L1 incident from the surface 101 of the semiconductor substrate 100 and measuring the scattered light L4 generated due to scattering of the incident light L3 that is incident inside the subsurface damaged layer 102. Therefore, the semiconductor substrate 100 having the subsurface damaged layer 102 that adversely affects a device can be determined in a non-destructive manner, subjected to appropriate processing such as removal of the subsurface damaged layer 102, and then caused to flow again to the device manufacturing process.

The method for evaluating a subsurface damaged layer according to the present invention includes a measurement step using S-polarized light in which the S-polarized laser light L1 is incident from the surface 101 of the semiconductor substrate 100 having the subsurface damaged layer 102 and the intensity of scattered light L4 scattered under the surface 101 is measured. By causing the S-polarized laser light L1 to be incident, it is possible to measure an amount of strain and a distribution status of the subsurface damaged layer 102 present in the vicinity of the surface 101.

The method for evaluating a subsurface damaged layer according to the present invention includes a classification step S353 of classifying the subsurface damaged layer 102 on the basis of extraction results in the location parameter extraction step S351 and/or the scale parameter extraction step S352. As described above, by visualizing and quantifying an amount of strain and a distribution status of the subsurface damaged layer 102, it is possible to classify the semiconductor substrate 100 suitable for device manufacturing.

According to the method for evaluating a subsurface damaged layer according to the present invention, an amount of strain and a distribution status of the subsurface damaged layer 102 in the depth direction can be evaluated by selecting polarized light of the laser light L1. Switching between S-polarized light and P-polarized light of the laser light L1 can be performed by the wavelength plate 12. Thus, the inspection region IA in the depth direction can be easily adjusted to be measured and evaluated without changing the measurement conditions such as the incident angle θ and the wavelength λ.

According to the method for evaluating a subsurface damaged layer according to the present invention, measurement sensitivity can be improved by measuring the scattered light L4 including elastic scattering. That is, most of the scattered light L4 generated due to scattering inside the subsurface damaged layer 102 is subjected to elastic scattering. In the present invention, highly sensitive measurement can be performed by measuring the scattered light L4 to include this elastic scattering.

According to the method for evaluating a subsurface damaged layer according to the present invention, by scanning the semiconductor substrate 100 with the laser light L1 while rotating the semiconductor substrate 100, the subsurface damaged layer 102 can be mapped at a high speed. Specifically, in a case of the 6-inch semiconductor substrate 100, the entire surface can be mapped within 5 minutes one by one.

The method for evaluating a subsurface damaged layer according to the present embodiment includes a step of setting a certain region AA (region setting step S31) and calculating a statistic of the certain region AA (statistic calculation step S32). As a result, it is possible to evaluate an amount of strain and a distribution status of the subsurface damaged layer 102 present in a wide range of the semiconductor substrate 100. In other words, by integrating and utilizing all measurement data instead of selecting a part of the measurement data, it is possible to visualize and/or quantify and evaluate the subsurface damaged layer 102 that cannot be evaluated according to the conventional method.

### <Second embodiment of evaluation step>

Hereinafter, a second embodiment of the evaluation step will be described.

Figs. 6 to 9 are explanatory diagrams of an evaluation step S50 in the evaluation method according to the embodiment.

The evaluation step S50 is a step of evaluating the subsurface damaged layer 102 of the semiconductor substrate 100 from the intensity of the scattered light L4 obtained in the measurement step S20. Specifically, the evaluation step S50 is a step of ascertaining an amount of strain and a distribution status of the subsurface damaged layer 102 introduced into the semiconductor substrate 100 by calculating a statistic on the basis of a plurality of intensity measurement values included in the scattered light intensity data.

The evaluation step S50 may include a data acquisition step S51 of acquiring an intensity measurement value of the scattered light L4 scattered under the surface 101 of the semiconductor substrate 100, measured by causing the laser light L1 to be incident from the surface 101 of the semiconductor substrate 100 in association with the measurement position information as scattered light intensity data, a peak specifying step S52 of specifying and labeling the intensity measurement value satisfying a predetermined standard, a statistic calculation step S53 of calculating a statistic on the basis of a plurality of intensity measurement values included in the scattered light intensity data of the scattered light L4, a strain amount calculation step S54 of further calculating an amount of strain under the surface of the semiconductor substrate from the calculated statistic, a mapping step S55 of creating a distribution diagram of a plurality of intensity measurement values included in the scattered light intensity data of the scattered light L4, an analysis step S56 of analyzing the subsurface damaged layer 102 of the semiconductor substrate by using a population parameter of a plurality of intensity measurement values included in the scattered light intensity data of the scattered light L4, and a classification step S57 of classifying a plurality of semiconductor substrates that are evaluation targets according to a classification criteria.

The data acquisition step S51 is a step of acquiring the intensity measurement value of the scattered light L4 obtained in the measurement step S20 as scattered light intensity data together with measurement position information associated therewith.

In the measurement step S20, a plurality of pieces of intensity information (intensity measurement values) of the scattered light L4 and measurement position information associated with each of the plurality of pieces of intensity information (intensity measurement values) are obtained as results of processing signals obtained by scanning the semiconductor substrate 100 with the laser light L1.

That is, the scattered light intensity data acquired in the data acquisition step S51 includes at least a plurality of pieces of intensity information (intensity measurement values) of the scattered light L4 and measurement position information associated with each of the plurality of pieces of intensity information (intensity measurement values).

The data acquisition step S51 may be a step of acquiring first scattered light intensity data and second scattered light intensity data in which each of a first intensity measurement value of scattered light measured by causing first laser light (for example, S-polarized light) having first penetration characteristics to be incident and a second intensity measurement value of scattered light measured by causing second laser light (for example, P-polarized light) having second penetration characteristics to be incident are associated with measurement position information including planar directions and a depth direction of the semiconductor substrate.

In this case, a difference in the penetration characteristics between the first laser light having the first penetration characteristics and the second laser light having the second penetration characteristics may be based on the penetration characteristics (polarization characteristics, a wavelength, an incident angle, and the like) of each piece of laser light or any combination thereof.

The peak specifying step S52 is a step of specifying and labeling an intensity measurement value that satisfies a predetermined standard.

For example, the peak specifying step S52 is a step of specifying and labeling an intensity measurement value greater than a predetermined upper limit value among a plurality of intensity measurement values included in the scattered light intensity data of the scattered light L4.

For example, the peak specifying step S52 is a step of specifying and labeling an intensity measurement value of which a numerical value is discontinuous in light of the measurement position information on the basis of the measurement position information and the intensity measurement value among a plurality of intensity measurement values included in the scattered light intensity data of the scattered light L4. The peak specifying step S52 is preferably performed on a plurality of intensity measurement values included in the scattered light intensity data of the scattered light L4 obtained by measuring the semiconductor substrate 100 having the planarized surface.

In such a peak specifying step S52, an intensity measurement value that does not match the spatial continuity or the typical scattered light intensity of the strain located in the subsurface damaged layer 102, that is, an intensity measurement value of scattered light estimated to be derived from a factor other than the strain may be labeled.

As a result, in the subsequent steps, it is possible to perform processing such as not using the intensity measurement value of the scattered light estimated to be derived from a factor other than the strain, or reducing the importance thereof.

The statistic calculation step S53 is a step of performing statistical processing on a plurality of intensity measurement values included in the scattered light intensity data of the scattered light L4 to calculate a statistic.

The statistic calculation step S53 may be a population parameter extraction step S53, and the population parameter extraction step S53 includes a location parameter extraction step S531 of extracting a location parameter (including, for example, one or more values selected from an average (arithmetic/geometric/harmonic), a median (quantile/order statistic), a most frequent value, and a class value) of a plurality of intensity measurement values included in the scattered light intensity data of the scattered light L4, and a scale parameter extraction step S352 of extracting a scale parameter (including, for example, one or more selected from a variance, a deviation value, a standard deviation, a mean deviation, a median absolute deviation, a range, and a full width at half maximum) of a plurality of intensity measurement values included in the scattered light intensity data of the scattered light L4.

The location parameter extraction step S531 is, for example, a step of extracting an intensity measurement value (most frequent value) of the scattered light L4 having the highest frequency in the subsurface damaged layer 102 from among a plurality of intensity measurement values included in the scattered light intensity data of the scattered light L4 measured in the measurement step S20. As the most frequent value, a value having the largest number of counts in the histogram of Fig. 6 may be employed. By extracting this most frequent value, the measured quality of the subsurface damaged layer 102 can be quantified, and it is possible to ascertain an amount of contained strain compared with other semiconductor substrates.

The scale parameter extraction step S532 is, for example, a step of extracting a full width at half maximum of a chevron function having a most frequent value as a vertex in the histogram of Fig. 6. By extracting the full width at half maximum, a variation in the subsurface damaged layer 102 of the semiconductor substrate 100 subjected to measurement can be quantified, and it is possible to ascertain the degree of variation in the amount of strain compared with other semiconductor substrates.

The statistic calculated in the statistic calculation step S53 may be calculated in association with the measurement position information including the planar directions and the depth direction.

As a result, a feature of a certain depth and a certain region (may be the entire semiconductor substrate 100) in the semiconductor substrate 100 can be ascertained on the basis of a statistic corresponding to the measurement position information.

The strain amount calculation step S54 is a step of further calculating an amount of strain under the surface of the semiconductor substrate from the calculated statistic.

An amount of strain may be calculated by performing some arithmetic processing on the statistic, or the statistic may be regarded as an amount of strain without any change.

An amount of strain is calculated by performing some arithmetic processing on the statistic calculated in association with the measurement position information including the planar directions and the depth direction, or is a value in which the statistic is regarded as an amount of strain without any change, and thus is associated with the measurement position information including the planar directions and the depth direction.

The mapping step S55 is a step of creating a distribution diagram of the intensity measurement values on the basis of threshold values for dividing a plurality of intensity measurement values from the lower limit to the upper limit included in the scattered light intensity data of the scattered light L4 into a plurality of values. The mapping step S55 includes a threshold value setting step S551.

In the threshold value setting step S551, for example, threshold values obtained by equally dividing a plurality of intensity measurement values from the lower limit value to the upper limit value included in the scattered light intensity data of the scattered light L4 into 256 can be provided.

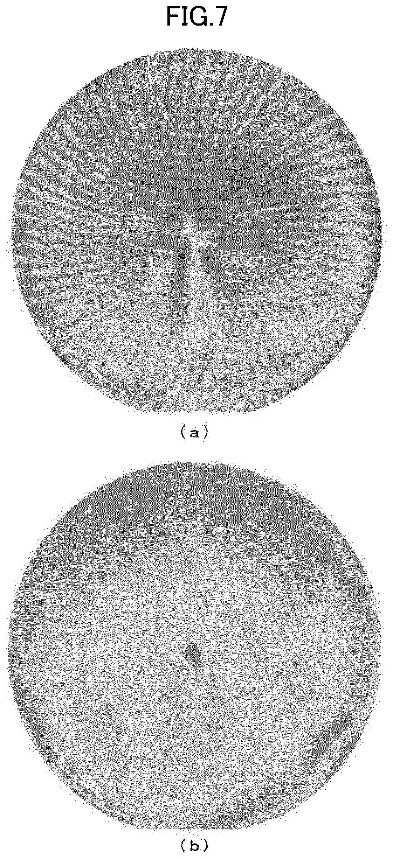

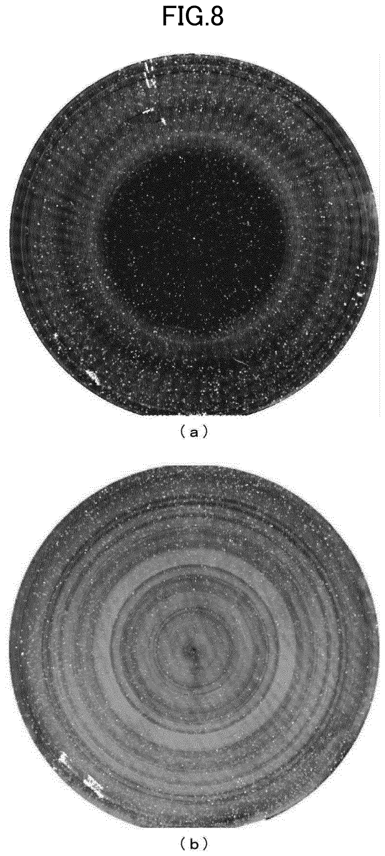

In such a case, in the mapping step S55, a contour diagram (for example, Figs. 7 and 8) in which an amount of strain and a distribution status of the subsurface damaged layer 102 are visualized can be created.

The contour diagram helps to visually distinguish between a region where the subsurface damaged layer 102 suitable for device manufacturing is distributed and a region where the subsurface damaged layer 102 unsuitable for device manufacturing is distributed.

The threshold value setting step S551 may not equally divide the calculated statistic from the lower limit value to the upper limit value.

For example, the threshold value setting step S551 may be a step of setting threshold values for dividing the calculated statistic from the lower limit value of to a predetermined upper limit value. According to such a threshold value setting step S551, in the distribution diagram of the intensity measurement values that can be created in the mapping step S55, it is possible to focus on a distribution of the intensity measurement values having a relatively small value that is smaller than a predetermined upper limit value in the calculated statistic and that is considered to be related to the strain under the surface of the semiconductor substrate 100.

In other words, such a threshold value setting step S551 helps to visually exclude an intensity measurement value exceeding the predetermined upper limit value specified in the peak specifying step S52 from an evaluation target as an intensity measurement value obtained from scattered light derived from the lattice defects, surface contamination or surface irregularities that is not a detection target.

In mapping step S55, in a case where the distribution diagram of the intensity measurement values is created, a visual marker may be attached to the intensity measurement value labeled in the peak specifying step S52 and having a discontinuous numerical value in light of a measurement position.

The analysis step S56 is a step of analyzing the quality of the subsurface damaged layer 102 of the semiconductor substrate 100 on the basis of the population parameter extracted in the population parameter extraction step S53.

That is, the analysis step S56 is a step of analyzing the quality of the subsurface damaged layer 102 of the semiconductor substrate 100 on the basis of the location parameter (including, for example, one or more values selected from an average (arithmetic/geometric/harmonic), a median (quantile/order statistic), a most frequent value, and a class value) and/or the scale parameter (including, for example, one or more selected from a variance, a deviation value, a standard deviation, a mean deviation, a median absolute deviation, a range, and a full width at half maximum) of a plurality of intensity measurement values included in the scattered light intensity data of the scattered light L4 extracted in the population parameter extraction step S53.

Fig. 6 is an explanatory diagram for describing an example of the analysis step S35 according to the embodiment, and is a histogram in which the horizontal axis represents an intensity of the scattered light L4 and the vertical axis represents the number of counts (frequency).

A case where the quality of the subsurface damaged layer 102 of the semiconductor substrate 100 is analyzed on the basis of the location parameter will be considered.

For example, the intensity (most frequent value) of the scattered light L4 having the highest frequency in the subsurface damaged layer 102 is extracted from a plurality of intensity measurement values included in the scattered light intensity data of the scattered light L4 measured in the measurement step S20. As the most frequent value, a value having the largest number of counts in the histogram of Fig. 6 may be employed.

By extracting this most frequent value, the quality of the subsurface damaged layer 102 of the semiconductor substrate 100 subjected to measurement can be quantified, and thus it is possible to ascertain an amount of contained strain compared with other semiconductor substrates.

A case of analyzing the quality of the subsurface damaged layer 102 of the semiconductor substrate 100 on the basis of the scale parameter will be considered.

For example, in the histogram of Fig. 6, a variation in the subsurface damaged layer 102 of the semiconductor substrate 100 subjected to measurement can be quantified by extracting the full width at half maximum of the chevron function having the most frequent value as a vertex.

That is, it is possible to ascertain how much the semiconductor substrate 100 has the degree of variation in the amount of strain compared with other semiconductor substrates.

In the analysis step S56 described above, for example, the semiconductor substrate 100 may be analyzed from two viewpoints of an amount of strain and a variation thereof by combining the most frequent value and the full width at half maximum.

The classification step S57 is a step of classifying the subsurface damaged layer 102 of the semiconductor substrate 100 on the basis of a combination of the population parameters extracted in the location parameter extraction step S531 and/or the scale parameter extraction step S532. The classification step S57 includes a classification criterion creation step S571 of creating in advance a classification criterion for features of the subsurface damaged layer of the semiconductor substrate on the basis of a combination of the extracted population parameters.

In the classification criterion creation step S571, for example, the classification criterion is created by setting the most frequent value obtained through the measurement using the S-polarized laser light L1, the full width at half maximum obtained through the measurement using the S-polarized laser light L1, the most frequent value obtained through the measurement using the P-polarized laser light L1, and the full width at half maximum obtained through the measurement using the P-polarized laser light L1 as axes of graphs in any combinations.

In the classification step S57, for example, the quality of the subsurface damaged layer 102 of the semiconductor substrate 100 subjected to measurement can be classified by plotting various population parameters obtained from a plurality of semiconductor substrates that are evaluation targets according to the classification criterion (an axis of the graph) created above (refer to Fig. 9).

Actually, a description will be made of an example of the result in which a most frequent value and a full width at half maximum were extracted from the intensity of the scattered light L4 obtained in the measurement step S21 using S-polarized light and the intensity of the scattered light L4 obtained in the measurement step S22 using P-polarized light (the location parameter extraction step S531 and the scale parameter extraction step S532), and the quality of the subsurface damaged layer 102 of the semiconductor substrate 100 was classified (classification step S57).

Fig. 9(a) is a graph in which the measurement step S20 and the evaluation step S50 are performed on a 6-inch 4H-SiC wafer manufactured by A, a 6-inch 4H-SiC wafer manufactured by B, a 6-inch 4H-SiC wafer manufactured by C, and a 6-inch 4H-SiC wafer manufactured by D, and the most frequent value of the S-polarized light is plotted on the horizontal axis and the most frequent value of the P-polarized light is plotted on the vertical axis.

As illustrated in Fig. 9(a), the quality of the subsurface damaged layer 102 including the depth direction can be evaluated by comparing and contrasting a plurality of semiconductor substrates 100 by using the most frequent value of the subsurface damaged layer 102 in the vicinity of the surface 101 measured by using S-polarized light and the most frequent value of the subsurface damaged layer 102 in the vicinity of the bulk layer 103 measured by using P-polarized light.

In other words, as illustrated in Fig. 9(a), features of the subsurface damaged layer in the depth direction can be classified and evaluated for the plurality of semiconductor substrates 100 by using the most frequent value of the S-polarized light and the most frequent value of the P-polarized light as biaxial classification criteria.

Fig. 9(b) is a graph in which the measurement step S20 and the evaluation step S30 are performed on a 6-inch 4H-SiC wafer manufactured by A, a 6-inch 4H-SiC wafer manufactured by B, a 6-inch 4H-SiC wafer manufactured by C, and a 6-inch 4H-SiC wafer manufactured by D, and the most frequent value of the S-polarized light is plotted on the horizontal axis and the full width at half maximum of the P-polarized light is plotted on the vertical axis.

As illustrated in Fig. 9(b), the quality of the subsurface damaged layer 102 including uniformity can be evaluated by comparing and contrasting a plurality of semiconductor substrates 100 by using the most frequent value of the subsurface damaged layer 102 in the vicinity of the surface 101 measured by using S-polarized light and the full width at half maximum of the subsurface damaged layer 102 in the vicinity of the bulk layer 103 measured by using P-polarized light.

In other words, as illustrated in Fig. 9(b), features of the uniformity of the subsurface damaged layer can be classified and evaluated for the plurality of semiconductor substrates 100 by using the most frequent value of the S-polarized light and the full width at half maximum of the P-polarized light as biaxial classification criteria.

Note that the evaluation step S50 according to the embodiment may employ a configuration of causing a processor of a computer to execute the data acquisition step S51, the peak specifying step S52, the statistic calculation step S53, the strain amount calculation step S54, the mapping step S55, the analysis step S56, and the classification step S57.

### <<Method for manufacturing semiconductor substrate>>

Next, a method for manufacturing a semiconductor substrate according to the present invention will be described in detail. In the following embodiment, the same reference numerals are given to constituents that are basically the same as those in the previous embodiment <<Method for evaluating subsurface damaged layer>>, and the description thereof will be made briefly.

A method for manufacturing a semiconductor substrate according to the present invention includes a step of evaluating the subsurface damaged layer 102 that adversely affects a device. Specifically, the method includes a step of causing the laser light L1 to be incident to the inside of the semiconductor substrate 100 and evaluating the subsurface damaged layer 102 of the semiconductor substrate 100 on the basis of an intensity of the scattered light L4.

Normally, in the case of manufacturing a semiconductor substrate, a slicing step of slicing an ingot and cutting out a wafer, and a grinding step and a polishing step for mirror-finishing the wafer are included. Along with these slicing, grinding, and polishing, the subsurface damaged layer 102 is introduced into the semiconductor substrate 100. The present invention is to evaluate the subsurface damaged layer 102 described above, and may be employed after the slicing step. The present invention may be employed after the grinding step. The present invention may be employed after the polishing step.

The method for manufacturing a semiconductor substrate according to the embodiment may include the measurement step S20 of causing the laser light L1 to be incident from the surface 101 of the semiconductor substrate 100 and measuring the scattered light L4 scattered inside the semiconductor substrate 100, and the evaluation step S30 of evaluating the subsurface damaged layer 102 of the semiconductor substrate 100 on the basis of the intensity of the scattered light L4.

The method for manufacturing a semiconductor substrate according to the embodiment may include a subsurface damaged layer removal step S40 of removing the subsurface damaged layer 102 of the semiconductor substrate 100 subsequent to the evaluation step S30.

Hereinafter, each step will be described in detail according to an embodiment of the present invention. Note that the measurement step S20 and the evaluation step S30 are similar to those in the above <<Method for evaluating subsurface damaged layer>>, and thus the description thereof will be made briefly.

### <Work-affected layer removal step S40>

The subsurface damaged layer removal step S40 is a step of removing the subsurface damaged layer 102 determined to be unsuitable in the evaluation step S30 or S50. As a method for removing the subsurface damaged layer 102, chemical mechanical polishing (CMP) or an etching method may be exemplified.

In the evaluation step S30, it is determined whether the subsurface damaged layer 102 is unsuitable for device manufacturing on the basis of the statistic of the intensity of the scattered light L4 for each certain region AA obtained in the statistic calculation step S32, the distribution diagram obtained by visualizing the distribution status of the strain of the subsurface damaged layer 102 obtained in the mapping step S34, and the like.

For example, in a case where a statistic is used to determine whether or not the subsurface damaged layer 102 is suitable, the presence of a statistic equal to or more than a predetermined threshold value may be regarded as the presence of an amount of strain equal to or more than a predetermined threshold value, and the subsurface damaged layer 102 may be determined to be unsuitable.

In the evaluation step S50, it is determined whether the subsurface damaged layer 102 is unsuitable for device manufacturing on the basis of statistics of a plurality of intensity measurement values included in the scattered light intensity data of the scattered light L4 obtained in the statistic calculation step S53, an amount of strain calculated from the statistics, a distribution diagram obtained by visualizing a distribution status of the intensity measurement values, and the like.

For example, in a case where an amount of strain is used to determine whether or not the subsurface damaged layer 102 is suitable, the subsurface damaged layer 102 corresponding to measurement position information including planar directions and a depth direction associated with an amount of strain equal to or more than a predetermined threshold value may be determined to be unsuitable.

Chemical mechanical polishing is a method of performing polishing by using both a mechanical action of a polishing pad and a chemical action of slurry.

An etching method may be a method used for etching the semiconductor substrate 100. For example, in a case where a semiconductor substrate material is SiC, a thermal etching method such as a SiVE method or a hydrogen etching method, or a wet etching method using a potassium hydroxide melt, a chemical liquid containing hydrofluoric acid, a potassium permanganate-based chemical liquid, a chemical liquid containing tetramethylammonium hydroxide, or the like may be exemplified. Usually, any chemical solution used in wet etching may be employed.

According to the method for manufacturing a semiconductor substrate of the present invention, it is possible to provide the semiconductor substrate 100 suitable for device manufacturing. That is, the semiconductor substrate 100 not including the subsurface damaged layer 102 that reduces a device yield can be discriminated and provided. As a result, the device yield can be improved.

According to the method for manufacturing a semiconductor substrate of the present embodiment, the semiconductor substrate 100 including the subsurface damaged layer 102 that reduces a device yield can be reused. That is, since the subsurface damaged layer 102 of the semiconductor substrate 100 can be evaluated in a non-destructive manner, the semiconductor substrate 100 suitable for device manufacturing can be manufactured through the subsurface damaged layer removal step S40 of removing the subsurface damaged layer 102 that is problematic.

### Examples

Hereinafter, the present invention will be described more specifically with reference to Examples.

Two 6-inch 4H-SiC wafers subjected to chemical mechanical polishing were prepared, and the subsurface damaged layer 102 was evaluated by using the evaluation system described in the embodiment of the present invention.

### <Cleaning step S10>

RCA cleaning was performed on the two 4H-SiC wafers.

### <Measurement step S20>

Measurement was performed on the 4H-SiC wafer subjected to the cleaning step S10 by using the evaluation system illustrated in Figs. 1 to 4. As illustrated in Fig. 4, the 4H-SiC wafer was disposed on the stage 30, and the laser light L1 was caused to be incident to the 4H-SiC wafer while the stage was rotated and translated parallelly, so that the entire surface of the semiconductor substrate 100 was scanned with the laser light L1 to measure the scattered light L4 including elastic scattering. The measurement was performed under the conditions that the measurement region was ϕ144 mm and the wavelength of the laser light L1 was 355 nm. The measurement time required for one 6-inch 4H-SiC wafer was 3 minutes.

In the measurement step S20, the measurement step S21 using S-polarized light in which S-polarized laser light L1 was incident and the measurement step S22 using P-polarized light in which P-polarized laser light L1 was incident were performed on the same semiconductor substrate 100.

### <Evaluation Step S30>

As illustrated in Fig. 5, the certain regions AA having a fan shape were set radially from the center of the semiconductor substrate 100 (region setting step S31). Next, the intensities of the scattered light L4 in a range corresponding to positions of the set certain regions AA are integrated (integration step S321). Next, the integrated value was divided by the number of pieces of acquired data in the certain regions AA, and an average value was calculated for each certain region AA (division step S322). Finally, threshold values for equally dividing values from the lower limit value to the upper limit value into 256 with the average value calculated in each certain region AA as a population was set (threshold value setting step S33), and a distribution diagram for visualizing an amount of strain and a distribution status of the subsurface damaged layer 102 was created (mapping step S34) .

Figs. 7 and 8 are distribution diagrams of the subsurface damaged layer 102 obtained in the evaluation step S30. Figs. 7(a) and 7(b) are distribution diagrams obtained in the measurement step S21 using S-polarized light in which the S-polarized laser light L1 is incident. Figs. 8(a) and 8(b) are distribution diagrams obtained in the measurement step S22 using P-polarized light in which the P-polarized laser light L1 is incident. The substrates in Figs. 7(a) and 8(a) are the same, and the substrates in Figs. 7(b) and 8(b) are the same.

As can be ascertained from Figs. 7 and 8, it can be seen that distribution diagrams with different patterns are obtained in the case of using the S-polarized laser light L1 and the case of using the P-polarized laser light L1 although the same semiconductor substrate 100 after chemical mechanical polishing is a measurement target. This is considered to be because the subsurface damaged layers 102 having different depths are measured because the easiness of detecting scattered light according to a generation depth of scattered light varies depending on the type of polarized light.

Here, a processing history of the semiconductor substrate 100 can be estimated on the basis of distribution diagrams of the subsurface damaged layers having different depths.

For example, the processing history in which the subsurface damaged layer 102 has been introduced into the semiconductor substrate 100 can be estimated from the distribution diagrams of the subsurface damaged layers 102 having different depths obtained on the basis of the measurement step S21 using S-polarized light and the measurement step S22 using P-polarized light.

That is, it can be ascertained that the pattern illustrated in Fig. 7 measured by using the S-polarized laser light L1 in which scattered light generated in the relatively shallow portion compared with the P-polarized light is easily detected reflects an amount of strain and a distribution status of the subsurface damaged layer 102 present in the vicinity of the surface 101. Since the pattern in Fig. 7 is very similar to the processing trace during grinding and polishing, it is considered that the subsurface damaged layer 102 introduced due to machining is reflected.

It can be ascertained that the pattern illustrated in Fig. 8 measured by using the P-polarized laser light L1 in which scattered light generated in a relatively deep portion compared with the S-polarized light is easily detected reflects an amount of strain and a distribution status of the subsurface damaged layer 102 present in the vicinity of the bulk layer 103. Since the pattern in Fig. 8 is very similar to a shape of a jig used in chucking during grinding and polishing, it is considered that the pattern reflects the subsurface damaged layer 102 introduced due to pressure and/or frictional heat during grinding and polishing.

As described above, it can be ascertained that the subsurface damaged layer 102 introduced due to steps involving machining is present in the lower layer of the surface 101 in spite of the semiconductor substrate 100 having the surface 101 subjected to extremely precise planarization through chemical mechanical polishing. By selecting polarized light (S-polarized light or P-polarized light) of the laser light L1, it is possible to obtain an amount of strain and a distribution status of the subsurface damaged layer 102 at any depth.

Incidentally, the evaluation of the subsurface damaged layer 102 of the embodiment is performed in a non-destructive manner. Therefore, the evaluated 4H-SiC wafer can be caused to flow in the device manufacturing process without being discarded.

Finally, a description will be made of an example of the result of extracting the most frequent value and the full width at half maximum from the intensity of the scattered light L4 obtained in the measurement step S21 using S-polarized light and the intensity of the scattered light L4 obtained in the measurement step S22 using P-polarized light (location parameter extraction step S351 and scale parameter extraction step S352), and classifying the quality of the subsurface damaged layer 102 of the semiconductor substrate 100 (classification step S353).

Fig. 9(a) is a graph in which the measurement step S20 and the evaluation step S30 are performed on a 6-inch 4H-SiC wafer manufactured by A, a 6-inch 4H-SiC wafer manufactured by B, a 6-inch 4H-SiC wafer manufactured by C, and a 6-inch 4H-SiC wafer manufactured by D, and the most frequent value of the S-polarized light is plotted on the horizontal axis and the most frequent value of the P-polarized light is plotted on the vertical axis.

As illustrated in Fig. 9(a), the quality of the subsurface damaged layer 102 including the depth direction can be evaluated by comparing and contrasting a plurality of semiconductor substrates 100 by using the most frequent value of the subsurface damaged layer 102 in the vicinity of the surface 101 measured by using S-polarized light and the most frequent value of the subsurface damaged layer 102 in the vicinity of the bulk layer 103 measured by using P-polarized light.

In other words, as illustrated in Fig. 9(a), features of the subsurface damaged layer in the depth direction can be classified and evaluated for the plurality of semiconductor substrates 100 by using the most frequent value of the S-polarized light and the most frequent value of the P-polarized light as classification criteria.

Fig. 9(b) is a graph in which the measurement step S20 and the evaluation step S30 are performed on a 6-inch 4H-SiC wafer manufactured by A, a 6-inch 4H-SiC wafer manufactured by B, a 6-inch 4H-SiC wafer manufactured by C, and a 6-inch 4H-SiC wafer manufactured by D, and the most frequent value of the S-polarized light is plotted on the horizontal axis and the full width at half maximum of the P-polarized light is plotted on the vertical axis.

As illustrated in Fig. 9(b), the quality of the subsurface damaged layer 102 including uniformity can be evaluated by comparing and contrasting a plurality of semiconductor substrates 100 by using the most frequent value of the subsurface damaged layer 102 in the vicinity of the surface 101 measured by using S-polarized light and the full width at half maximum of the subsurface damaged layer 102 in the vicinity of the bulk layer 103 measured by using P-polarized light.

In other words, as illustrated in Fig. 9(b), features of the uniformity of the subsurface damaged layer can be classified and evaluated for the plurality of semiconductor substrates 100 by using the most frequent value of the S-polarized light and the full width at half maximum of the P-polarized light as classification criteria.

### Reference Signs List

- 100: Semiconductor substrate
- 101: Surface
- 102: Work-affected layer
- 1021: Oxide layer
- 1022: Strained layer
- 103: Bulk layer
- 10: Light projection system
- 11: Laser output unit
- 12: Wavelength plate (optical adjuster)
- 20: Light receiving system
- 21: Objective lens
- 22: Imaging lens
- 23: Beam splitter
- 24: Light receiving sensor
- 25: Slit (light selector)
- 30: Stage
- 40: Housing
- 50: Signal processing unit
- 60: Data processing unit
- 70: Control unit
- L1: Laser light
- L2: Reflected light
- L3: Incident light
- L4: Scattered light
- PD: Penetration depth
- PL: Penetration length
- AA: Certain region
- IA: Inspection region
- S10: Cleaning step
- S20: Measurement step
- S21: Measurement step using S-polarized light
- S22: Measurement step using P-polarized light
- S30: Evaluation step

## Claims

1. A method for evaluating a subsurface damaged layer of a semiconductor substrate, the method comprising:
a measurement step of causing laser light having penetration characteristics to be incident from a surface of a semiconductor substrate having a subsurface damaged layer under the surface and measuring an intensity of scattered light scattered under the surface; and
an evaluation step of evaluating the subsurface damaged layer on the basis of the intensity of the scattered light obtained in the measurement step.

2. The method for evaluating a subsurface damaged layer according to claim 1, wherein the semiconductor substrate is a silicon carbide substrate.

3. The method for evaluating a subsurface damaged layer according to claim 1 or 2, wherein
the subsurface damaged layer includes strain, and
the evaluation step includes calculating an amount of the strain on the basis of the intensity of the scattered light.

4. The method for evaluating a subsurface damaged layer according to claim 3, wherein
the measurement step includes acquiring the intensity of the scattered light having a predetermined depth in association with position information in planar directions of the semiconductor substrate, and
the evaluation step includes calculating the amount of strain in association with the position information.

5. The method for evaluating a subsurface damaged layer according to any one of claims 1 to 4, wherein the laser light has a photon energy larger than a bandgap of the semiconductor substrate.

6. The method for evaluating a subsurface damaged layer according to claim 5, wherein the laser light has a photon energy of about 101 to 1220 of the bandgap of the semiconductor substrate.

7. The method for evaluating a subsurface damaged layer according to any one of claims 1 to 6, further comprising a measurement step using S-polarized light in which S-polarized laser light is caused to be incident from the surface of the semiconductor substrate and an intensity of scattered light scattered under the surface is measured.

8. The method for evaluating a subsurface damaged layer according to any one of claims 1 to 6, further comprising a measurement step using P-polarized light in which P-polarized laser light is caused to be incident from the surface of the semiconductor substrate and an intensity of scattered light scattered under the surface is measured.

9. The method for evaluating a subsurface damaged layer according to any one of claims 1 to 6, further comprising
a measurement step using S-polarized light in which S-polarized laser light is caused to be incident from the surface of the semiconductor substrate and an intensity of scattered light scattered under the surface is measured; and
a measurement step using P-polarized light in which P-polarized laser light is caused to be incident from the surface and an intensity of scattered light scattered under the surface is measured.

10. The method for evaluating a subsurface damaged layer according to any one of claims 1 to 9, wherein the semiconductor substrate has a planarized surface.

11. The method for evaluating a subsurface damaged layer according to any one of claims 1 to 10, wherein the laser light is incident to the semiconductor substrate at an incident angle θ of 40° ≤ θ ≤ 80° with respect to a normal line of the surface of the semiconductor substrate.

12. The method for evaluating a subsurface damaged layer according to any one of claims 1 to 11, further comprising:
an inspection region information acquisition step of acquiring information regarding an inspection region in a depth direction from the surface of the semiconductor substrate, wherein
the measurement step includes a light projection condition acquisition step of acquiring light projection conditions including penetration characteristics of the laser light such that the laser light penetrates into the inspection region; and a light selection step of selectively measuring scattered light generated in the inspection region.

13. The method for evaluating a subsurface damaged layer according to claim 12, wherein the measurement step includes an optical adjustment step of adjusting the penetration characteristics of the laser light.

14. The method for evaluating a subsurface damaged layer according to claim 13, wherein the light selection step includes shielding scattered light generated in a non-inspection region outside the inspection region.

15. The method for evaluating a subsurface damaged layer according to claim 14, wherein the light selection step includes shielding reflected light and/or scattered light generated on a back surface of the semiconductor substrate.

16. The evaluation method according to any one of claims 1 to 15, wherein the measurement step includes a scanning step of scanning the semiconductor substrate with the laser light while rotating the semiconductor substrate.

17. The evaluation method according to any one of claims 1 to 16, wherein the measurement step is a step of measuring the scattered light including elastic scattering.

18. An evaluation system comprising:
a stage capable of holding a semiconductor substrate that is a measurement target;
a light projection system capable of irradiating the semiconductor substrate with laser light having penetration characteristics;
a light receiving system capable of receiving scattered light that is scattered under a surface of the semiconductor substrate; and
a data processing unit configured to evaluate a subsurface damaged layer under the surface of the semiconductor substrate on the basis of an intensity of the scattered light.

19. The evaluation system according to claim 18, wherein
the subsurface damaged layer includes strain, and
the data processing unit calculates an amount of the strain on the basis of the intensity of the scattered light.

20. The evaluation system according to claim 19, wherein
the light projection system irradiates the entire surface of the semiconductor substrate with the laser light,
the light receiving system acquires the intensity of the scattered light scattered at a predetermined depth over planar directions of the semiconductor substrate in association with position information in the planar directions, and
the data processing unit records the calculated amount of strain in association with the position information.

21. The evaluation system according to any one of claims 18 to 20, wherein the light projection system emits the laser light having a photon energy larger than a bandgap of the semiconductor substrate.

22. The evaluation system according to claim 21, wherein the light projection system emits the laser light having a photon energy of about 101 to 1220 of the bandgap of the semiconductor substrate.

23. The evaluation system according to any one of claims 18 to 22, further comprising:
the stage capable of holding a semiconductor substrate that is a measurement target;
the light projection system capable of emitting S-polarized and/or P-polarized laser light;
the light receiving system capable of receiving scattered light that is scattered under a surface of the semiconductor substrate; and
the data processing unit configured to evaluate a subsurface damaged layer on the basis of an intensity of the scattered light measured by using the S-polarized and/or P-polarized laser light.

24. The evaluation system according to any one of claims 18 to 23, wherein the light projection system irradiates the semiconductor substrate with the laser light at an incident angle θ of 40° ≤ θ ≤ 80° with respect to a normal line of the surface of the semiconductor substrate.

25. The evaluation system according to any one of claims 18 to 24, further comprising:
an inspection region setting unit that sets an inspection region in a depth direction from the surface of the semiconductor substrate, wherein
the light projection system determines light projection conditions including at least penetration characteristics such that the laser light penetrates into the inspection region, and
the light receiving system determines light receiving conditions such that scattered light generated in the inspection region is selectively measured.

26. The evaluation system according to claim 25, wherein the light projection system includes an optical adjuster that adjusts the penetration characteristics of the laser light, and the light receiving system includes a light selector that selectively measures scattered light generated in the inspection region.

27. The evaluation system according to claim 26, wherein the light selector includes a slit that shields scattered light generated in a non-inspection region outside the inspection region.

28. The evaluation system according to claim 27, wherein the light selector includes a slit that shields reflected light and/or scattered light generated on a back surface of the semiconductor substrate.

29. The evaluation system according to any one of claims 18 to 28, wherein the semiconductor substrate is a silicon carbide substrate.

30. A method for evaluating a subsurface damaged layer of a semiconductor substrate, the method comprising:
a data acquisition step of acquiring, as scattered light intensity data, an intensity measurement value of scattered light that is scattered under a surface of a semiconductor substrate, the intensity measurement value being measured by causing laser light to be incident from the surface of the semiconductor substrate, in association with measurement position information;
a statistic calculation step of calculating a statistic of a plurality of intensity measurement values included in the scattered light intensity data; and
an evaluation step of evaluating a subsurface damaged layer of the semiconductor substrate on the basis of the statistic.

31. The method for evaluating a semiconductor substrate according to claim 30, wherein the semiconductor substrate is a silicon carbide substrate.

32. The method for evaluating a semiconductor substrate according to claim 30 or 31, wherein
the data acquisition step includes acquiring a plurality of types of the scattered light intensity data in which each of a plurality of types of the intensity measurement values measured by causing a plurality of pieces of laser light having different penetration characteristics to be incident is associated with measurement position information including planar directions and a depth direction of the semiconductor substrate, and
the statistic calculation step includes calculating a statistic of the intensity measurement values in association with the measurement position information including the planar directions and the depth direction.

33. The method for evaluating a semiconductor substrate according to any one of claims 30 to 32, wherein the laser light has polarization characteristics.

34. The method for evaluating a semiconductor substrate according to claim 33, wherein the laser light is S-polarized light and/or P-polarized light.

35. The method for evaluating a semiconductor substrate according to any one of claims 30 to 34, wherein the evaluation step includes a strain amount calculation step of calculating an amount of strain under the surface of the semiconductor substrate from the statistic.

36. The method for evaluating a semiconductor substrate according to any one of claims 30 to 35, wherein the evaluation step further includes a peak specifying step of specifying and labeling the intensity measurement value greater than a predetermined upper limit value.

37. The method for evaluating a semiconductor substrate according to any one of claims 30 to 36, wherein
the semiconductor substrate has a planarized surface, and
the evaluation step further includes a peak specifying step of specifying and labeling the intensity measurement value having a discontinuous numerical value in light of the measurement position information on the basis of the measurement position information and the intensity measurement value.

38. The method for evaluating a semiconductor substrate according to any one of claims 30 to 37, further comprising a mapping step of creating a distribution diagram of the intensity measurement values on the basis of threshold values for dividing the intensity measurement values from a lower limit to an upper limit into a plurality of values.

39. The method for evaluating a semiconductor substrate according to claim 38, wherein the mapping step includes creating a distribution diagram of the intensity measurement values on the basis of a plurality of threshold values such that an amount of strain is identifiable in a stepwise manner.

40. The method for evaluating a semiconductor substrate according to any one of claims 30 to 39, wherein
the evaluation step includes
a population parameter extraction step of extracting a population parameter of the plurality of intensity measurement values; and
an analysis step of analyzing the semiconductor substrate on the basis of the extracted population parameter.

41. The method for evaluating a semiconductor substrate according to claim 40, wherein the population parameter extraction step includes a location parameter extraction step of extracting a location parameter of the plurality of intensity measurement values.

42. The method for evaluating a semiconductor substrate according to claim 41, wherein the location parameter extraction step is a step of extracting a most frequent value of the plurality of the intensity measurement values.

43. The method for evaluating a semiconductor substrate according to claim 41 or 42, wherein the population parameter extraction step includes a scale parameter extraction step of extracting a scale parameter of the plurality of intensity measurement values.

44. The method for evaluating a semiconductor substrate according to claim 43, wherein the scale parameter extraction step is a step of extracting a full width at half maximum of the plurality of the intensity measurement values.

45. The method for evaluating a semiconductor substrate according to any one of claims 40 to 44, wherein
the population parameter extraction step is a step of extracting a plurality of types of population parameters from the plurality of the intensity measurement values for one semiconductor substrate, and
in the analysis step, the semiconductor substrate is analyzed on the basis of a combination of the plurality of types of population parameters.

46. The method for evaluating a semiconductor substrate according to claim 45, wherein, in the analysis step, the semiconductor substrate is analyzed on the basis of a combination of a location parameter and a scale parameter.

47. The method for evaluating a semiconductor substrate according to claim 46, further comprising a classification step of classifying a plurality of semiconductor substrates on the basis of the combination of the location parameter and the scale parameter.

48. The method for evaluating a semiconductor substrate according to claim 47, further comprising:
a classification criterion creation step of creating in advance a classification criterion for a feature of the subsurface damaged layer of the semiconductor substrate according to the combination of the location parameter and the scale parameter obtained through analysis of the plurality of the semiconductor substrates that are evaluation targets, wherein
the analysis step includes a classification step of classifying the plurality of semiconductor substrates that are evaluation targets in light of the classification criterion on the basis of the combination of the location parameter and the scale parameter.

49. The method for evaluating a semiconductor substrate according to any one of claims 40 to 44, wherein
the data acquisition step includes acquiring first scattered light intensity data and second scattered light intensity data in which each of a first intensity measurement value of scattered light measured by causing first laser light having first penetration characteristics to be incident and a second intensity measurement value of scattered light measured by causing second laser light having second penetration characteristics to be incident is associated with the measurement position information including planar directions of the semiconductor substrate,
the statistic calculation step includes calculating a first statistic and a second statistic respectively from the first intensity measurement value and the second intensity measurement value associated with the measurement position information,
the population parameter extraction step is a step of extracting a first population parameter and a second population parameter respectively from the calculated first statistic and second statistic, and
the analysis step is a step of analyzing the semiconductor substrate on the basis of a combination of the first population parameter and the second population parameter.

50. The method for evaluating a semiconductor substrate according to claim 49, wherein the first laser light is S-polarized light, and the second laser light is P-polarized light.

51. The method for evaluating a semiconductor substrate according to claim 49 or 50, further comprising:
a classification criterion creation step of creating in advance a classification criterion for a feature of the subsurface damaged layer of the semiconductor substrate according to the combination of the first population parameter and the second population parameter obtained through analysis of a plurality of semiconductor substrates that are evaluation targets, and
the analysis step includes a classification step of classifying the plurality of semiconductor substrates that are evaluation targets in light of the classification criterion on the basis of the combination of the first population parameter and the second population parameter.

52. A method for manufacturing a semiconductor substrate, the method comprising:
a step of evaluating the subsurface damaged layer of the semiconductor substrate by using the evaluation method or the evaluation system according to any one of claims 1 to 51;
a specifying step of specifying a layer including a predetermined amount of strain as a result of the evaluation; and
a removal step of removing the specified layer.
